# EUROPEAN PATENT APPLICATION

(11) **EP 4 734 726 A1**
(43) Date of publication of application: **29.04.2026**
(21) Application number: 23953642.8
(22) Date of filing: 28.09.2023
(51) Int. Cl.: H10K 59/82, H10K 59/80, H10K 59/122

(54) **DISPLAY SUBSTRATE AND DISPLAY DEVICE**

(71) Applicant: BOE Technology Group Co., Ltd., Beijing 100015 (CN); Chengdu BOE Optoelectronics Technology Co., Ltd., Chengdu, Sichuan 611731 (CN)
(72) Inventor: DONG, Xiangdan, Beijing 100176 (CN); LEE, Ansu, Beijing 100176 (CN); FAN, Cong, Beijing 100176 (CN); ZHANG, Wei, Beijing 100176 (CN); DU, Mengmeng, Beijing 100176 (CN); YAN, Jun, Beijing 100176 (CN); HUANG, Yao, Beijing 100176 (CN); WANG, Qiwei, Beijing 100176 (CN); QIU, Haijun, Beijing 100176 (CN); HU, Ming, Beijing 100176 (CN); JIANG, Zhiliang, Beijing 100176 (CN); XIE, Taofeng, Beijing 100176 (CN); ZHAO, Yongliang, Beijing 100176 (CN); ZHANG, Yi, Beijing 100176 (CN); WANG, Rui, Beijing 100176 (CN); ZHENG, Hai, Beijing 100176 (CN); JI, Fengli, Beijing 100176 (CN); HAO, Xueguang, Beijing 100176 (CN); WANG, Hongli, Beijing 100176 (CN); QIAO, Yong, Beijing 100176 (CN); ZHENG, Kening, Beijing 100176 (CN); LI, Langtao, Beijing 100176 (CN); WANG, Yu, Beijing 100176 (CN)
(74) Representative: Brötz, Helmut
(86) International application number: PCT/CN2023/122530
(87) International publication number: WO 2025/065493

(57) **Abstract**

A display substrate and a display device. The display substrate comprises a substrate base, and a conductive structure and a first inorganic layer which are located on the substrate base. The substrate base comprises a first area and a second area; the conductive structure is located in the first area and the second area; the first inorganic layer is located on the side of the conductive structure away from the substrate base and is located in the first area and the second area. In at least part of the first area, an insulating layer is provided between the first inorganic layer and the conductive structure, and in at least part of the second area, the first inorganic layer is in contact with the surface of the conductive structure. In the display substrate provided in the present disclosure, the first inorganic layer is provided in both the first area and the second area, and in the second area, the first inorganic layer is in direct contact with the surface of the conductive structure, thereby implementing protection of the conductive structure by the first inorganic layer and preventing defects caused by etching of the conductive structure due to exposure.

## Description

### TECHNICAL FIELD

The embodiments of the present disclosure relate to a display substrate and a display device.

### BACKGROUND

Organic light-emitting diode (OLED) display products have a wide range of applications due to their rich colors, fast response time, foldability, etc. An organic light-emitting diode display device includes tandem devices. By adding at least one light-emitting layer and a charge generation layer to the tandem device, the lifetime and brightness of light-emitting devices can be increased, and power consumption can be lowered to meet the needs of users for the service life and power consumption of display devices.

### SUMMARY

A display substrate and a display device are provided in the present disclosure.

The present disclosure provides a display substrate, which includes: a base substrate, and a conductive structure and a first inorganic layer on the base substrate. The base substrate includes a first region and a second region; the conductive structure is located in the first region and the second region of the base substrate; and the first inorganic layer is located on a side of the conductive structure away from the base substrate and located in the first region and the second region. In at least a part of the first region, an insulating layer is disposed between the first inorganic layer and the conductive structure, and in at least a part of the second region, the first inorganic layer is in contact with a surface of the conductive structure.

For example, according to an embodiment of the present disclosure, the insulating layer has a thickness greater than that of any layer in the first inorganic layer and the conductive structure.

For example, according to an embodiment of the present disclosure, a portion of the conductive structure located in the second region includes a power supply signal line.

For example, according to an embodiment of the present disclosure, the first region includes a display region, and the second region includes a part of a non-display region; the display region includes a plurality of sub-pixels, each of at least a part of the sub-pixels includes a light-emitting functional layer, and the light-emitting functional layer includes a plurality of film layers; the display substrate includes a defining structure, the defining structure includes a portion of the first inorganic layer located in the first region, the defining structure is located between the light-emitting functional layer and the base substrate, and a portion of the defining structure located between adjacent sub-pixels is configured to disconnect at least one film layer in the light-emitting functional layer.

For example, according to an embodiment of the present disclosure, the insulating layer includes a first organic layer, a portion of the first organic layer located in the first region is disposed between the first inorganic layer and the conductive structure, the defining structure further includes at least one raised part in the first organic layer that is in contact with a surface of the first inorganic layer, and at least a part of an edge of the raised part is retracted inward relative to an edge of the first inorganic layer in the defining structure.

For example, according to an embodiment of the present disclosure, the conductive structure includes at least two sub-conductive structures that are stacked; in a part of the first region, other organic layers are disposed between two adjacent sub-conductive structures of the at least two sub-conductive structures, and in the second region, two adjacent sub-conductive structures of the at least two sub-conductive structures are at least partially in direct contact with each other, or a second inorganic layer is at least disposed between two sub-conductive structures.

For example, according to an embodiment of the present disclosure, the base substrate further includes a third region, the third region includes a part of the non-display region, a portion of the conductive structure located in the third region includes at least one ring-shaped first isolation column, and the first isolation column does not overlap with the first organic layer in a direction perpendicular to the base substrate; each of the at least a part of the sub-pixels further includes a first electrode and a second electrode located on both sides of the light-emitting functional layer, and the first electrode is located between the light-emitting functional layer and the base substrate; at least a portion of the first region close to the third region or at least a portion of the third region close to the first region includes a second isolation column, the second isolation column includes a stacked structure formed by the first inorganic layer and the first organic layer, in the second isolation column, an edge of the first inorganic layer includes a first protrusion protruding relative to at least a part of an edge of the first organic layer, and the first isolation column and the second isolation column are configured to disconnect at least one of the light-emitting functional layer and the second electrode.

For example, according to an embodiment of the present disclosure, the second isolation column includes a plurality of second isolation columns surrounding a center of the third region, in at least one second isolation column, the first organic layer is provided with a first groove, and the first inorganic layer includes an opening exposing the first groove; the display substrate further includes a second organic layer located on a side of the first inorganic layer away from the base substrate, and the second organic layer includes a first covering portion that covers the first groove and an edge of the first inorganic layer close to the first groove.

For example, according to an embodiment of the present disclosure, the base substrate further includes a third region, the third region includes a part of the non-display region and is provided with at least one ring-shaped first isolation column, the first isolation column includes a first isolation layer and a second isolation layer that are stacked, and the second isolation layer is located on a side of the first isolation layer away from the base substrate; a portion of the first organic layer located in the third region includes the first isolation layer, a portion of the first inorganic layer located in the third region includes the second isolation layer, and the second isolation layer is disposed to protrude relative to an edge of the first isolation layer to form a second protrusion, or a third organic layer is further disposed between the first organic layer and the base substrate, a portion of the third organic layer located in the third region includes the first isolation layer, a portion of the first inorganic layer located in the third region includes the second isolation layer, and the second isolation layer is disposed to protrude relative to an edge of the first isolation layer to form a second protrusion.

For example, according to an embodiment of the present disclosure, a side of the first isolation layer away from the base substrate is provided with a second groove, and the second isolation layer exposes the second groove; the display substrate further includes a second organic layer located on a side of the first inorganic layer away from the base substrate, and the second organic layer includes a second covering portion that at least covers the second groove.

For example, according to an embodiment of the present disclosure, a portion of the second organic layer located in the first region further includes a pixel defining pattern, the pixel defining pattern includes a plurality of first openings and a plurality of second openings, one sub-pixel is corresponding to at least one first opening, the light-emitting functional layer of the sub-pixel is at least partially located in the first opening corresponding to the sub-pixel, and the first opening is configured to expose the first electrode, and the second opening is configured to expose an edge of the defining structure.

For example, according to an embodiment of the present disclosure, each of the at least a part of the sub-pixels further includes a first electrode and a second electrode located on both sides of the light-emitting functional layer, and a pixel circuit, the first electrode is located between the light-emitting functional layer and the base substrate, and the first inorganic layer is located between the first electrode and the base substrate; the insulating layer includes a first organic layer, in a part of the first region, the first organic layer includes a via hole, the first electrode is electrically connected with the pixel circuit through the via hole, and the first inorganic layer covers at least a part of an inner wall of the via hole.

For example, according to an embodiment of the present disclosure, a position of the first organic layer, other than the via hole, includes at least one raised part in contact with a surface of the first inorganic layer in the defining structure, the defining structure includes the raised part, and an edge of the raised part is retracted inward relative to an edge of the first inorganic layer in the defining structure.

For example, according to an embodiment of the present disclosure, the display substrate further includes: at least one ring of dams that surrounds the display region, at least part of film layers of the dam being located on a side of the conductive structure away from the base substrate. An orthographic projection of the power supply signal line on the base substrate overlaps with an orthographic projection of the at least one ring of dams on the base substrate, a portion of the power supply signal line located in the second region extends along a first direction, a portion of the at least one ring of dams located in the second region includes a strip-shaped dam extending along a second direction, at least a portion of the first inorganic layer located in the second region extends along the second direction, and the first direction and the second direction intersect.

For example, according to an embodiment of the present disclosure, at least a portion of the first inorganic layer located in the second region includes at least one inorganic layer pattern, and the inorganic layer pattern covers at least a part of an edge of the power supply signal line that extends along the first direction.

For example, according to an embodiment of the present disclosure, the at least one inorganic layer pattern includes a plurality of inorganic layer patterns, the strip-shaped dam includes at least one strip-shaped dam, and the strip-shaped dam and the plurality of inorganic layer patterns are alternately disposed along the first direction.

For example, according to an embodiment of the present disclosure, an edge of the strip-shaped dam covers an edge of the inorganic layer pattern, or an edge of the strip-shaped dam is flush with at least a part of an edge of the inorganic layer pattern.

For example, according to an embodiment of the present disclosure, the base substrate includes a fourth region, the fourth region surrounds a part of the display region, and an orthographic projection, on the base substrate, of a portion of the power supply signal line located in the fourth region is completely located in an orthographic projection of the at least one ring of dams on the base substrate.

For example, according to an embodiment of the present disclosure, in the direction perpendicular to the base substrate, the portion of the power supply signal line located in the fourth region does not overlap with the first inorganic layer.

For example, according to an embodiment of the present disclosure, the power supply signal line includes a first power supply signal line and a second power supply signal line, the fourth region is only provided with the second power supply signal line, and the second region is provided with the first power supply signal line and the second power supply signal line.

For example, according to an embodiment of the present disclosure, the display region includes a plurality of sub-pixels, each of at least a part of the sub-pixels includes a first electrode, a light-emitting functional layer and a second electrode that are stacked in sequence, and the light-emitting functional layer includes a plurality of film layers; the display substrate includes a defining structure, the defining structure includes a portion of the first inorganic layer located in the first region, the defining structure is located between the light-emitting functional layer and the base substrate, and a portion of the defining structure located between adjacent sub-pixels is configured to disconnect at least one film layer in the light-emitting functional layer; the display substrate further includes a second organic layer located on a side of the first inorganic layer away from the base substrate, a portion of the second organic layer located in the first region includes a pixel defining pattern, the pixel defining pattern includes a plurality of first openings, one sub-pixel is corresponding to at least one first opening, the light-emitting functional layer of the sub-pixel is at least partially located in the first opening corresponding to the sub-pixel, and the first opening is configured to expose the first electrode, a portion of the second organic layer located in the second region includes a film layer of the dam.

For example, according to an embodiment of the present disclosure, the insulating layer includes a first organic layer, a portion of the first organic layer located in the second region includes a first film layer of the dam, a portion of the second organic layer located in the second region includes a second film layer of the dam, the second film layer is located on a side of the first film layer away from the base substrate, and in the direction perpendicular to the base substrate, a portion of the inorganic layer pattern that overlaps with the dam is located between the first film layer and the second film layer.

For example, according to an embodiment of the present disclosure, at least one of the plurality of inorganic layer patterns includes a main body portion extending along the second direction and a widening portion located on at least one side of the main body portion in the first direction, in the second direction, the widening portion has a length smaller than that of the main body portion, in the first direction, the widening portion has a width smaller than a size of the dam, and the widening portion covers an edge of the power supply signal line that extends along the second direction.

For example, according to an embodiment of the present disclosure, the display substrate further includes: an encapsulation layer located on a side of the second organic layer away from the base substrate. At least a part of an edge of the first protrusion closest to a center of the third region, in the second isolation column is covered by the second organic layer, and at least a part of an edge of the second organic layer is covered by the encapsulation layer.

For example, according to an embodiment of the present disclosure, the display substrate further includes: an encapsulation layer located on a side of the second organic layer away from the base substrate. An edge furthest away from the first region in a portion of the first inorganic layer covering the first organic layer and protruding relative to an edge of the first organic layer is covered by the second organic layer, and the encapsulation layer covers at least a part of an edge of the second organic layer.

For example, according to an embodiment of the present disclosure, the first inorganic layer includes a plurality of notches exposing the first organic layer, and the second organic layer fills the plurality of notches.

For example, according to an embodiment of the present disclosure, the base substrate includes a bending region, the insulating layer includes a first organic layer, the display substrate further includes a second organic layer, the second organic layer is located on a side of the first inorganic layer away from the conductive structure, and portions of the conductive structure, the first inorganic layer, the first organic layer and the second organic layer located in the bending region are all configured to be bendable, a portion of the first inorganic layer located in the bending region includes a hole, a portion of the first organic layer located in the bending region includes a third groove, and the second organic layer fills the hole and the third groove.

An embodiment of the present disclosure provides a display substrate, which includes: a base substrate, and a first inorganic layer, a first organic layer, a second organic layer and a conductive structure on the base substrate. The base substrate includes a first sub-region and a second sub-region; the first inorganic layer is located in the first sub-region and the second sub-region of the base substrate; the first organic layer is located between a film layer where the first inorganic layer is located, and the base substrate; the second organic layer is located on a side of the film layer where the first inorganic layer is located, away from the base substrate; and the conductive structure is located between the film layer where the first inorganic layer is located, and the base substrate. A portion of the first inorganic layer located in the first sub-region is in contact with the first organic layer, a portion of the first inorganic layer located in the second sub-region is in contact with the conductive structure, and in the first sub-region, at least a part of an edge of the first inorganic layer covering the first organic layer, is covered by the second organic layer.

For example, according to an embodiment of the present disclosure, the base substrate further includes a third sub-region, the first sub-region includes a part of a non-display region, the second sub-region includes a part of the non-display region, and the third sub-region includes a part of a display region; the display region includes a plurality of sub-pixels, each of at least a part of the sub-pixels includes a light-emitting functional layer, and the light-emitting functional layer includes a plurality of film layers; the display substrate includes a defining structure, the defining structure includes a portion of the first inorganic layer located in the third sub-region, the defining structure is located between the light-emitting functional layer and the base substrate, and a portion of the defining structure located between the adjacent sub-pixels is configured to disconnect at least one film layer of the light-emitting functional layer.

For example, according to an embodiment of the present disclosure, each of the at least a part of the sub-pixels further includes a first electrode and a second electrode located on both sides of the light-emitting functional layer, and the first electrode is located between the light-emitting functional layer and the base substrate; a portion of the second organic layer located in the third sub-region includes a pixel defining pattern located on a side of the first electrode away from the base substrate, the pixel defining pattern includes a plurality of first openings and a plurality of second openings, one sub-pixel is corresponding to at least one first opening, the light-emitting functional layer of the sub-pixel is at least partially located in the first opening corresponding to the sub-pixel, and the first opening is configured to expose the first electrode and the second opening is configured to expose an edge of the defining structure.

For example, according to an embodiment of the present disclosure, a portion of the first organic layer located in the first sub-region includes a groove, a portion of the first inorganic layer located in the first sub-region includes a hole exposing at least a part of the groove, and a portion of the second organic layer located in the first sub-region fills the hole and the groove.

For example, according to an embodiment of the present disclosure, the base substrate further includes a third sub-region, the first sub-region includes a part of a non-display region, the second sub-region includes a part of the non-display region, and the third sub-region includes a part of a display region, the display region includes a plurality of sub-pixels, each of at least a part of the sub-pixels includes a light-emitting functional layer and a first electrode and a second electrode located on both sides of the light-emitting functional layer, and the first electrode is located between the light-emitting functional layer and the base substrate; the non-display region includes at least one ring-shaped first isolation column, the first isolation column includes a first isolation layer and a second isolation layer that are stacked, the first isolation layer is located between the second isolation layer and the base substrate, and the second isolation layer protrudes relative to an edge of the first isolation layer to disconnect the light-emitting functional layer and the second electrode; a portion of the second organic layer located in the non-display region includes the first isolation layer, and a portion of the first inorganic layer located in the non-display region includes the second isolation layer.

For example, according to an embodiment of the present disclosure, a side of the first isolation layer away from the base substrate is provided with a first sub-groove, and the second isolation layer exposes the first sub-groove; a portion of the second organic layer located in the non-display region covers the first sub-groove and an edge of the second isolation layer close to the first sub-groove.

For example, according to an embodiment of the present disclosure, the display substrate is provided with at least one second isolation column, the second isolation column is located on a side of the first isolation column away from a center of a part of the non-display region that the first isolation column surrounds, the second isolation column includes a third isolation layer and a fourth isolation layer that are stacked, the third isolation layer is located between the fourth isolation layer and the base substrate, and an edge of the fourth isolation layer protrudes relative to an edge of the third isolation layer to disconnect at least one of the light-emitting functional layer and the second electrode; a distance between at least a part of the fourth isolation layer and the base substrate is greater than a distance between the second isolation layer and the base substrate.

For example, according to an embodiment of the present disclosure, a side of the third isolation layer away from the base substrate is provided with a second sub-groove, and the fourth isolation layer exposes the second sub-groove; the second organic layer covers the second sub-groove and an edge of the fourth isolation layer close to the second sub-groove.

An embodiment of the present disclosure provides a display substrate, which includes: a base substrate, and an inorganic layer, a conductive structure and at least one ring of dams on the base substrate. The base substrate includes a display region and a non-display region surrounding the display region; the inorganic layer is located in the display region and the non-display region of the base substrate; the conductive structure is located between the inorganic layer and the base substrate and including a power supply signal line; the at least one ring of dams is located in the non-display region and surrounding the display region, at least part of film layers of the dam being located on a side of the conductive structure away from the base substrate. The non-display region includes a first non-display region located on a side of the display region, a portion of the power supply signal line located in the first non-display region extends along a first direction, a portion of the dam located in the first non-display region includes a strip-shaped dam extending along a second direction and overlapping with the power supply signal line, a portion of the inorganic layer located in the first non-display region includes an inorganic layer pattern extending along the second direction, and in a direction perpendicular to the base substrate, an edge of the strip-shaped dam overlaps with at least a part of an edge of the inorganic layer pattern.

For example, according to an embodiment of the present disclosure, the non-display region includes a second non-display region surrounding the display region, an orthographic projection, on the base substrate, of a portion of the power supply signal line located in the second non-display region, is completely located in an orthographic projection of the at least one ring of dams on the base substrate.

For example, according to an embodiment of the present disclosure, in the direction perpendicular to the base substrate, a portion of the power supply signal line located in the second non-display region does not overlap with the inorganic layer.

For example, according to an embodiment of the present disclosure, the power supply signal line includes a first power supply signal line and a second power supply signal line, the second non-display region is only provided with the second power supply signal line, and the first non-display region is provided with the first power supply signal line and the second power supply signal line.

For example, according to an embodiment of the present disclosure, the at least one inorganic layer pattern includes a plurality of inorganic layer patterns, the strip-shaped dam includes at least one strip-shaped dam, and the strip-shaped dam and the plurality of inorganic layer patterns are alternately disposed along the first direction.

For example, according to an embodiment of the present disclosure, the inorganic layer pattern covers an edge of the power supply signal line that extends along the first direction.

For example, according to an embodiment of the present disclosure, the display substrate further includes: a first organic layer located between the inorganic layer and the base substrate, a portion of the first organic layer located in the display region including a planar layer. A portion of the first organic layer located in the non-display region includes a first film layer of the dam, and a portion of the inorganic layer that overlaps with the dam in the direction perpendicular to the base substrate covers at least a part of an edge of the first film layer.

For example, according to an embodiment of the present disclosure, the display substrate further includes: a second organic layer located on a side of the inorganic layer away from the base substrate. A portion of the second organic layer located in the non-display region includes a second film layer of the dam, the second film layer is located on a side of the first film layer away from the base substrate, and in the direction perpendicular to the base substrate, a portion of the inorganic layer pattern that overlaps with the dam is located between the first film layer and the second film layer.

For example, according to an embodiment of the present disclosure, the display substrate further includes: an encapsulation layer located on a side of the second organic layer away from the base substrate, the encapsulation layer includes a portion in contact with the dam and a portion in contact with the inorganic layer.

An embodiment of the present disclosure provides a display device, which includes any display substrate as mentioned above.

### BRIEF DESCRIPTION OF DRAWINGS

In order to clearly illustrate the technical solution of the embodiments of the present disclosure, the drawings of the embodiments will be briefly described in the following; it is obvious that the described drawings are only related to some embodiments of the present disclosure and thus are not limitative of the present disclosure.
Fig. 1 is a schematic plan view of a display substrate according to an embodiment of the present disclosure.
Fig. 2 is a schematic diagram of a partial sectional structure of a first region and a second region shown in Fig. 1.
Fig. 3 is a plan view of a partial structure of the second region shown in Fig. 1.
Fig. 4 is a scanning electron microscope image of a sectional view taken along a line AA' shown in Fig. 3.
Fig. 5 and Fig. 6 are schematic diagrams of partial sectional structures of the display substrate according to different examples of the embodiments of the present disclosure.
Fig. 7 is a schematic diagram of a partial planar structure of the second region shown in Fig. 1.
Fig. 8 is a schematic diagram of pixel arrangement in the display substrate according to an embodiment of the present disclosure.
Fig. 9 and Fig. 10 are schematic diagrams of partial sectional structures taken along line BB' shown in Fig. 8, according to different examples of an embodiment of the present disclosure.
Fig. 11 is a schematic diagram of a planar structure of the first region and a third region of the display substrate shown in Fig. 1.
Fig. 12 is a schematic diagram of a partial planar structure of the third region shown in Fig. 11.
Fig. 13 is a schematic diagram of a partial sectional structure of the display substrate shown in Fig. 12 in an example.
Fig. 14 to Fig. 16 are diagrams illustrating process steps for forming the display substrate shown in Fig. 13.
Fig. 17 is a schematic diagram of a partial sectional structure of the display substrate shown in Fig. 12 in another example.
Fig. 18 and Fig. 19 are schematic diagrams of partial sectional structures of the third region of the display substrate shown in Fig. 1 in different examples.
Fig. 20 is a schematic diagram illustrating a crack of an encapsulation layer at the boundary of a first inorganic layer.
Fig. 21 is a scanning electron microscope image illustrating the crack of the encapsulation layer at the boundary of the first inorganic layer.
Fig. 22 and Fig. 23 are structural diagrams in different examples of the embodiments of the present disclosure, at a location of Fig. 20.
Fig. 24 and Fig. 25 are schematic diagrams of partial structures of a bending region in the display substrate shown in Fig. 1, in different examples.
Fig. 26 is a schematic diagram of a partial sectional structure of a non-display region of the display substrate according to an embodiment of the present disclosure.
Fig. 27 is a schematic diagram of a partial sectional structure of the display substrate according to an example of the embodiment of the present disclosure.
Fig. 28 is a schematic diagram of a partial sectional structure of the display substrate according to another example of the embodiment of the present disclosure.
Fig. 29 is a schematic block diagram of a display device according to another embodiment of the present disclosure.

### DETAILED DESCRIPTION

In order to make objects, technical details and advantages of the embodiments of the present disclosure apparent, the technical solutions of the embodiment will be described in a clearly and fully understandable way in connection with the drawings related to the embodiments of the present disclosure. It is obvious that the described embodiments are just a part but not all of the embodiments of the present disclosure. Based on the described embodiments herein, those skilled in the art can obtain other embodiment(s), without any inventive work, which should be within the scope of the present disclosure.

Unless otherwise defined, all the technical and scientific terms used herein have the same meanings as commonly understood by one of ordinary skill in the art to which the present disclosure belongs. The terms "first," "second," etc., which are used in the description and the claims of the present application for disclosure, are not intended to indicate any sequence, amount or importance, but distinguish various components. The terms "comprise," "comprising," "include," "including," etc., are intended to specify that the elements or the objects stated before these terms encompass the elements or the objects and equivalents thereof listed after these terms, but do not preclude the other elements or objects.

The features "parallel", "perpendicular" and "same" used in the embodiments of the present disclosure all include features such as "parallel", "perpendicular" and "same" in the strict sense, and the cases having certain errors, such as "approximately parallel", "approximately perpendicular", "approximately the same" or the like, taking into account measurements and errors associated with the measurement of a particular quantity (e.g., limitations of the measurement system), and indicate being within an acceptable range of deviation for a particular value as determined by one of ordinary skill in the art. For example, "approximately" may indicate being within one or more standard deviations, or within 10% or 5% of the stated value. In the case that the quantity of a component is not specifically indicated below in the embodiments of the present disclosure, it means that the component may be one or more, or may be understood as at least one. "At least one" means one or more, and "plurality" means at least two. The "same layer arrangement" mentioned in the present disclosure refers to the structure formed by two (or more) structures formed by the same deposition process and patterned by the same patterning process, and their materials may be the same or different. The phrase "integral structure" in the present disclosure refers to a structure in which two (or more) structures formed through the same deposition process and patterned through the same patterning process are connected with each other, and their materials may be the same or different.

The inventor of the present application has found during the research that a light-emitting functional layer in a light-emitting element may include a plurality of light-emitting layers that are stacked, such as tandem devices, and such tandem devices have the characteristics of low power consumption and long service life. However, at least two of the plurality of light-emitting layers in the Tandem device have a charge generation layer (CGL) disposed therebetween, with a relatively large conductivity in the charge generation layer. For example, when the charge generation layer is a whole-surface film layer, the charge generation layer of two adjacent light-emitting elements is a continuous film layer, and there exists a lateral transfer of charges, leading to low-grayscale monochromaticity shift in the display substrate. For example, crosstalk is more likely to occur between adjacent sub-pixels, resulting in color shift in the display substrate. For another example, the charge generation layer is easy to cause crosstalk between sub-pixels of different colors at low brightness, resulting in low gray scale color shift.

The present disclosure provides a display substrate, which includes a base substrate, a conductive structure and a first inorganic layer located on the base substrate. The base substrate includes a first region and a second region; the conductive structure is located in the first region and the second region; the first inorganic layer is located on a side of the conductive structure away from the base substrate and located in the first region and the second region. In at least a part of the first region, an insulating layer is disposed between the first inorganic layer and the conductive structure, and in at least a part of the second region, the first inorganic layer is in contact with a surface of the conductive structure. In the display substrate according to the present disclosure, the first inorganic layer is disposed in both the first region and the second region, and in the second region, the first inorganic layer is in direct contact with the surface of the conductive structure, it is beneficial to realize the protection of the conductive structure by the first inorganic layer and prevent the conductive structure from being etched due to exposure, thereby causing defects.

The present disclosure provides a display substrate, which includes a base substrate, a first inorganic layer, a first organic layer, a second organic layer, and a conductive structure located on the base substrate. The base substrate includes a first sub-region and a second sub-region; the first inorganic layer is located in the first sub-region and the second sub-region of the base substrate; the first organic layer is located between a film layer where the first inorganic layer is located, and the base substrate; the second organic layer is located on a side of the film layer where the first inorganic layer is located, away from the base substrate; the conductive structure is located between the film layer where the first inorganic layer is located, and the base substrate. A portion of the first inorganic layer located in the first sub-region is in contact with the first organic layer, a portion of the first inorganic layer located in the second sub-region is in contact with the conductive structure, and in the first sub-region, at least a part of an edge of the first inorganic layer covering the first organic layer, is covered by the second organic layer. In the display substrate according to the present disclosure, at least a part of the edge of the first inorganic layer covering the first organic layer is set to be covered by the second organic layer, which helps preventing an encapsulation layer that covers the edge of the first inorganic layer, from cracking.

The present disclosure provides a display substrate, which includes a base substrate, an inorganic layer, a conductive structure, and at least one ring of dams located on the base substrate. The base substrate includes a display region and a non-display region surrounding the display region; the inorganic layer is located in the display region and the non-display region of the base substrate; the conductive structure is located between the inorganic layer and the base substrate, and includes a power supply signal line; the at least one ring of dams is located in the non-display region and surrounds the display region, and at least part of film layers of the dam is located on a side of the conductive structure away from the base substrate. The non-display region includes a first non-display region located on a side of the display region, a portion of the power supply signal line located in the first non-display region extends along a first direction, a portion of the dam located in the first non-display region includes a strip-shaped dam extending along a second direction and overlapping with the power supply signal line, a portion of the inorganic layer located in the first non-display region includes an inorganic layer pattern extending along the second direction, and in a direction perpendicular to the base substrate, an edge of the strip-shaped dam overlaps with at least a part of an edge of the inorganic layer pattern. In the display substrate according to the present disclosure, the inorganic layer including the inorganic layer pattern is disposed in the first non-display region where the direction of extension of the power supply signal line and the direction of extension of the strip-shaped dam intersect, and this facilitates covering the edge of the power supply signal line in order to avoid undesirable phenomena such as etching on the edge of the power supply signal line.

The display substrate and the display device provided in the present disclosure will be described below with reference to the accompanying drawings.

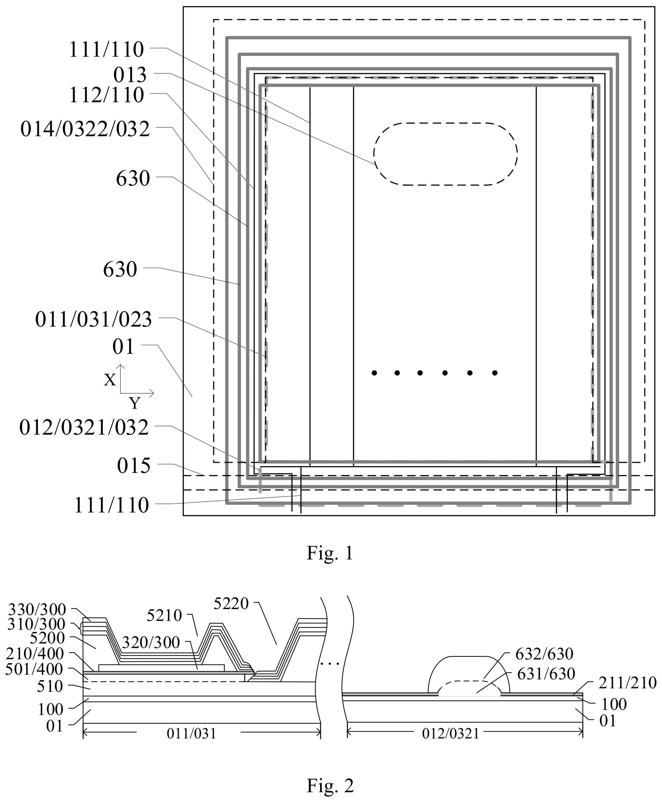

Fig. 1 is a schematic plan view of a display substrate according to an embodiment of the present disclosure. Fig. 2 is a schematic diagram of a partial sectional structure of a first region and a second region shown in Fig. 1.

As shown in Fig. 1 and Fig. 2, the display substrate includes a base substrate 01, and a conductive structure 100 and a first inorganic layer 210 located on the base substrate 01. The base substrate 01 includes a first region 011 and a second region 012. The conductive structure 100 is located in the first region 011 and the second region 012 of the base substrate 01, the first inorganic layer 210 is located on a side of the conductive structure 100 away from the base substrate 01 and located in the first region 011 and the second region 012. In at least a part of the first region 011, an insulating layer is disposed between the first inorganic layer 210 and the conductive structure 100; and in at least a part of the second region 012, the first inorganic layer 210 is in contact with a surface of the conductive structure 100. In the display substrate according to the present disclosure, the first inorganic layer 210 is disposed in both the first region 011 and the second region 012, and in the second region 012, the first inorganic layer 210 is in direct contact with the surface of the conductive structure 100, thus enabling the first inorganic layer 210 to protect the conductive structure 100 and preventing an undesirable phenomenon caused by the conductive structure 100 being exposed and thus etched.

In some examples, as shown in Fig. 1 and Fig. 2, the first region 011 includes a display region, and the second region 012 includes a part of a non-display region. For example, the display region is a region for image display and the non-display region is a region in which no image is displayed. For example, the second region 012 is located on a side of the first region 011. For example, the second region 012 may be a region in which an electric contact pad is disposed. For example, the second region 012 may be a region used for electrical connection with a circuit board.

In some examples, as shown in Fig. 2, the display region includes a plurality of sub-pixels 300, each sub-pixel 300 of at least a part of the sub-pixels 300 includes a light-emitting functional layer 310, and the light-emitting functional layer 310 includes a plurality of film layers; each sub-pixel 300 of the at least a part of the sub-pixels described above further includes a first electrode 320 and a second electrode 330 located on both sides of the light-emitting functional layer 310, the first electrode 320 is located between the light-emitting functional layer 310 and the base substrate 01, and the first inorganic layer 210 is located between the first electrode 320 and the base substrate 01.

For example, as shown in Fig. 2, the light-emitting functional layer 310 includes a charge generation layer. For example, the light-emitting functional layer may be a light-emitting functional layer included in an organic light-emitting element. For example, each sub-pixel 300 located in the display region includes a light-emitting element.

For example, as shown in Fig. 2, the light-emitting functional layer 310 may include a first light-emitting layer (EML), a charge generation layer (CGL) and a second light-emitting layer (EML) that are stacked, and the charge generation layer is located between the first light-emitting layer and the second light-emitting layer. With a relatively strong conductivity in the charge generation layer, the light-emitting functional layer 310 may be endowed with advantages such as prolonged service life, low power consumption, and high brightness. For example, compared with the light-emitting functional layer 310 having no charge generation layer disposed therein, the sub-pixel 300 can nearly double its luminance by disposing the charge generation layer in the light-emitting functional layer 310.

For example, the light-emitting element of the same sub-pixel 300 may be the tandem light-emitting element, e.g., Tandem OLED.

For example, the charge generation layer may include an N-type charge generation layer and a P-type charge generation layer.

For example, in each sub-pixel 300, the light-emitting functional layer 310 may further include a hole injection layer (HIL), a hole transport layer (HTL), an electron transport layer (ETL), and an electron injection layer (EIL).

For example, the hole injection layer, the hole transport layer, the electron transport layer, the electron injection layer, and the charge generation layer are all film layers shared by a plurality of sub-pixels 300, and may be referred to as common layers. For example, the above common layers and the second electrode 330 may be film layers that are formed using an open mask.

For example, the second light-emitting layer may be located between the first light-emitting layer and the second electrode 330, the hole injection layer may be located between the first electrode 320 and the first light-emitting layer. For example, the electron transport layer may also be disposed between the charge generation layer and the first light-emitting layer. For example, the hole transport layer may be disposed between the second light-emitting layer and the charge generation layer. For example, the electron transport layer and the electron injection layer may be disposed between the second light-emitting layer and the second electrode 330.

For example, in the same sub-pixel 300, the first light-emitting layer and the second light-emitting layer may be light-emitting layers that emit light of the same color. For example, in the same sub-pixel 300, the first light-emitting layer and the second light-emitting layer may be light-emitting layers that emit light of different colors. By disposing, in the same sub-pixel 300, light-emitting layers that emit light of different colors, the light emitted by a plurality of light-emitting layers included in the sub-pixel 300 can be mixed into white light. A color film layer is disposed to adjust the color of the light emitted by each sub-pixel 300.

For example, the material of the electron transport layer may include aromatic heterocyclic compounds, e.g., imidazole derivatives such as benzimidazole derivatives, imidazopyridine derivatives, benzimidazole phenanthridine derivatives, etc.; zine derivatives such as pyrimidine derivatives, triazine derivatives, etc.; compounds containing a nitrogen-containing six-membered ring structure such as quinoline derivatives, isoquinoline derivatives, phenanthroline derivatives, etc. (compounds with phosphine oxide substituents on a heterocyclic ring are also included), or the like.

For example, the material of the charge generation layer may be a material containing a phosphorus-oxygen group, or a material containing triazine.

For example, the ratio of the electron mobility of the charge generation layer to the electron mobility of the electron transport layer is 10⁻² ~ 10².

For example, the first electrode 320 may be an anode and the second electrode 330 may be a cathode. For example, the cathode may be formed from a material with a high conductivity and a low work function. For example, the cathode may be made of a metal material. For example, the anode may be formed from a transparent conductive material with a high work function.

For example, as shown in Fig. 2, an orthographic projection, on the base substrate 01, of the second electrode 330 in at least a part of the sub-pixels 330 is a whole-surface structure. For example, the second electrode 300 may be a common electrode shared by the plurality of sub-pixels 300.

In some examples, as shown in Fig. 2, the display substrate includes a defining structure 400, the defining structure 400 includes a portion of the first inorganic layer 210 in the first region 011, the defining structure 400 is located between the light-emitting functional layer 310 and the base substrate 01, and a portion of the defining structure 400 located between adjacent sub-pixels 400 is configured to disconnect at least one of the light-emitting functional layers 310. For example, the defining structure 400 may disconnect the above charge generation layer to avoid crosstalk between the sub-pixels 300 of different colors that are disposed adjacently. For example, all the film layers in the light-emitting functional layer 310 that are located between the charge generation layer and the base substrate 01 may be isolated on an edge of the defining structure 400. For example, all the film layers in the light-emitting functional layer will be isolated on the edge of the defining structure 400. For example, the second electrode 330 may be isolated on the edge of the defining structure 400, and may also be disposed continuously.

In some examples, as shown in Fig. 2, an insulating layer 510 has a thickness greater than that of any layer in the first inorganic layer 210 and the conductive structure 100. For example, the conductive structure 100 may be a metal structure.

For example, the insulating layer may be one film layer, and may also include a plurality of film layers. For example, the insulating layer includes a plurality of organic layers, or the plurality of film layers included in the insulating layer may include organic layers and inorganic layers, or metal layers may be disposed between the plurality of film layers included in the insulating layer.

In some examples, as shown in Fig. 2, the above insulating layer includes at least one organic layer, the at least one organic layer includes a first organic layer 510, a portion of the first organic layer 510 located in the first region 011 is disposed between the first inorganic layer 210 and the conductive structure 100, the defining structure 400 further includes at least one raised part 501 in the first organic layer 510 that is in contact with the surface of the first inorganic layer 210, and at least a part of an edge of the raised part 501 is retracted inward relative to an edge of the first inorganic layer 210 in the defining structure 400. For example, the first organic layer 510 includes a plurality of raised parts 501, the plurality of raised parts 501 is disposed in one-to-one correspondence with the plurality of sub-pixels 300, and an orthographic projection of a light-emitting region of the sub-pixel 300 on the base substrate 01 is located inside an orthographic projection of the raised part 501 on the base substrate 01.

For example, as shown in Fig. 2, the defining structure is composed of the first inorganic layer 210 and the raised parts 501 of the first organic layer 510. For example, an orthographic projection of the first electrode 320 of the sub-pixel 300 on the base substrate 01 is completely located inside an orthographic projection of the defining structure 400 on the base substrate 01. For example, an orthographic projection of the protrusion 501 on the base substrate 01 is completely located inside an orthographic projection of the first inorganic layer 210 on the base substrate 01. For example, the first organic layer 510 may have a thickness of 2 microns. For example, a portion of the first organic layer 510 located in the display region may be a planarization layer (PLN) closest to the first electrode 320 of the sub-pixel 300. For example, the material of the first inorganic layer 210 may include silicon nitride, silicon oxide, or silicon nitride. For example, the material of the first organic layer 510 may include materials such as polyimide.

In some examples, as shown in Fig. 2, the display substrate further includes a second organic layer 520 located on a side of the first inorganic layer 210 away from the base substrate 01. A portion of the second organic layer 520 located in the first region 011 includes a pixel defining pattern 5200, the pixel defining pattern 5200 includes a plurality of first openings 5210 and a plurality of second openings 5220, one sub-pixel 300 is corresponding to at least one first opening 5210, the light-emitting functional layer 310 of the sub-pixel 300 is at least partially located in the first opening 5210 corresponding to the sub-pixel 300, and the first opening 5210 is configured to expose the first electrode 320 and the second opening 5220 is configured to expose an edge of the defining structure 400. For example, one sub-pixel 300 is corresponding to one first opening 5210, and the light-emitting functional layer 310 located inside the first opening 5210 emits light through contact with the first electrode 320 and the second electrode 330. For example, the first opening 5210 is used to define the light-emitting region of the sub-pixel 300. For example, the edge of the defining structure 400, which is exposed by the second opening 5220, is used to disconnect at least one layer in the light-emitting functional layer 310. For example, the pixel defining pattern 5200 includes a pixel defining portion surrounding the first opening 5210 and the second opening 5220, and the light-emitting functional layer may include a portion located inside the first opening 5210 and a portion located on the pixel defining portion.

In some examples, as shown in Fig. 1 and Fig. 2, the display substrate further includes at least one ring of dams 630 that surrounds the display region, a part of film layers of the dam 630 is located on a side of the conductive structure 100 away from the base substrate 01. The dam 630 may be used to prevent the organic layer in an encapsulation layer 700 (described later) from overflowing the base substrate 01 during its manufacturing. Fig. 1 schematically illustrates two dams 630, but without limiting thereto, the number of the dams 630 may be set according to product requirements. For example, different dams may have the same or different heights. For example, different dams may have the same or different widths. For example, a part of the film layers of the dam may be located between the conductive structure and the base substrate.

In some examples, as shown in Fig. 2, a portion of the first organic layer 510 located in the second region 012 includes a first film layer 631 of the dam 630, a portion of the second organic layer 520 located in the second region 012 includes a second film layer 632 of the dam 630, and the second film layer 632 is located on a side of the first film layer 631 away from the base substrate 01. For example, the dam 630 may include the first film layer 631 and the second film layer 632 that are stacked, the portion of the first organic layer 510 located in the second region 012 serves as the first film layer 631 of the dam 630, and the portion of the second organic layer 520 located in the second region 012 serves as the second film layer 632 of the dam 630. For example, the first film layer 631 and the second film layer 632 may use the same material. For example, the thickness of the second film layer 632 may be greater than the thickness of the first film layer 631. Certainly, the embodiment of the present disclosure is not limited thereto, and the dam 630 may further include more film layers.

In some examples, as shown in Fig. 1 and Fig. 2, a portion of the conductive structure 100 located in the second region 012 includes a power supply signal line 110. For example, the power supply signal line 110 may be a signal line that transmits at least one of a VDD power supply signal and a VSS power supply signal. Fig. 2 schematically illustrates that the conductive structure 100 includes a one-layer structure, but without limiting thereto, the conductive structure may include a multi-layer structure. One organic layer, or one organic layer and one inorganic layer, may be disposed between two adjacent layers of the multi-layer structure located in the first region. For example, different layers in the conductive structure have different boundaries. For example, the conductive structure may include a three-layer conductive structure, such as a first conductive structure, a second conductive structure and a third conductive structure that are disposed in sequence along the direction perpendicular to the base substrate, the first conductive structure is located between the second conductive structure and the base substrate 01, and is of the conductive structures located in the second region. The second conductive structure is located on a side of the first conductive structure away from the display region, the third conductive structure is located on a side of the first conductive structure close to the display region, both the second conductive structure and the third conductive structure overlap with the first conductive structure, and the second conductive structure does not overlap with the third conductive structure. For example, the third conductive structure may include a plurality of via holes in order to achieve outgassing for the organic layers located between the third conductive structure and the base substrate. For example, in the above three-layer conductive structure, only the first conductive structure overlaps with the dam in the direction perpendicular to the base substrate. For example, the above second conductive structure does not overlap with the first inorganic layer. For example, the above first conductive structure is in contact with the surface of the first inorganic layer. For example, an edge of the above third conductive structure that overlaps with the first conductive structure overlaps with the first inorganic layer. For example, the above one-layer structure may include one metal layer, and may also include a plurality of metal layers that are stacked, such as titanium/aluminum/titanium stacked film layers.

Fig. 2 does not show other film layers between the conductive structure 100 and the base substrate 01, for example, between the conductive structure 100 and the base substrate 01, there is also at least one metal layer, such as a structure including a gate of a thin film transistor of a pixel circuit, a gate line electrically connected with the gate, and multiple insulating layers, such as a film layer including a gate insulating layer, a buffer layer, an interlayer insulating layer, etc. The structures between the pixel defining pattern and the dam are omitted in Fig. 2.

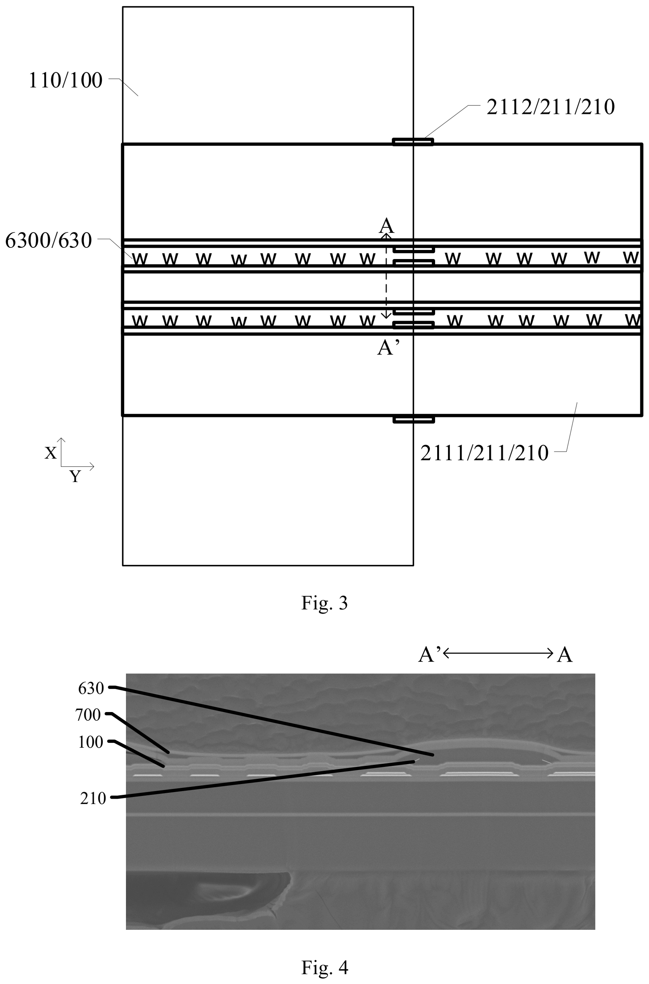

Fig. 3 is a plan view of a partial structure of the second region shown in Fig. 1. Fig. 4 is a scanning electron microscope image of a sectional view taken along a line AA' shown in Fig. 3.

In some examples, as shown in Fig. 1 and Fig. 3, an orthographic projection of the power supply signal line 110 on the base substrate 01 overlaps with an orthographic projection of the at least one ring of dams 630 on the base substrate 01, a portion of the power supply signal line 110 located in the second region 012 extends along a first direction, a portion of the at least one ring of dams 630 located in the second region 012 includes a strip-shaped dam 6300 extending along a second direction, at least a portion of the first inorganic layer 210 located in the second region 012 extends along the second direction, and the first direction and the second direction intersect. For example, the first direction may be a direction X shown in Fig. 1 and the second direction may be a direction Y shown in Fig. 1. For example, the intersection angle between the first direction and the second direction may be 80 to 100 degrees. For example, the first direction is perpendicular to the second direction. The embodiment of the present disclosure is not limited thereto, and the first direction and the second direction are interchangeable.

In some examples, as shown in Fig. 3, at least a portion of the first inorganic layer 210 located in the second region 012 includes at least one inorganic layer pattern 211, and the inorganic layer pattern 211 extends along the second direction and covers an edge of the power supply signal line 110 that extends along the first direction. For example, the inorganic layer pattern 211 is in contact with the surface of the power supply signal line 110. For example, a part of the edge of the power supply signal line 110 is simultaneously covered by the inorganic layer pattern 211 and the strip-shaped dam 6300. For example, the edge of the power supply signal line 110 includes a portion that is only covered by the first inorganic layer 210, a portion that is only covered by the dam 630, and a portion that is simultaneously covered by the first inorganic layer 210 and the strip-shaped dam 630. For example, the inorganic layer pattern 211 may be a strip-shaped film layer.

According to the display substrate provided in the present disclosure, the portion of the first inorganic layer located in the display region is used to form a defining structure in order to disconnect at least one of the light-emitting functional layers of the adjacent sub-pixels of different colors, thereby achieving the purpose of crosstalk reduction. Meanwhile, the portion of the first inorganic layer located in the non-display region covers the edge of the power supply signal line exposed by the dam, which can improve strict reliability verification conditions in the non-display region and avoid the associated growing dark spot (GDS) issue.

In some examples, as shown in Fig. 3, the at least one inorganic layer pattern 211 includes a plurality of inorganic layer patterns 211, the number of the strip-shaped dams 6300 is at least one, and the strip-shaped dam 6300 and the plurality of inorganic layer patterns 211 are alternately disposed along the first direction. For example, the number of the strip-shaped dams 6300 is two, the number of the inorganic layer patterns 211 is three, the inorganic layer patterns 211 and the strip-shaped dams 6300 are alternately disposed along the first direction, and the inorganic layer patterns 211 are located on both sides of the strip-shaped dams 6300.

In some examples, as shown in Fig. 3 and Fig. 4, an edge of the strip-shaped dam 6300 covers at least a part of an edge of the inorganic layer pattern 211, or an edge of the strip-shaped dam 6300 is flush with a part of the edge of the inorganic layer pattern 211. For example, the edges, close to the strip-shaped dam 6300, of the inorganic layer patterns 211 located on both sides of the strip-shaped dam 6300 both stretch into the strip-shaped dam 6300, in order to prevent a part of the conductive structure 100 from being exposed when the strip-shaped dam 6300 and the inorganic layer patterns 211 are mismatched in their location distribution due to process reasons. For example, the inorganic layer pattern 211 covers the conductive structure 100 exposed by the strip-shaped dam 6300.

In some examples, as shown in Fig. 2 to Fig. 4, in the direction perpendicular to the base substrate 01, a portion of the inorganic layer pattern 211 that overlaps with the dam 630 is located between the first film layer 631 and the second film layer 632. For example, the first film layer 631 and the second film layer 632 may be prepared from the same material, and at other locations than the location where the first inorganic layer 210 is disposed between the first film layer 631 and the second film layer 632 of the dam 630, there may be no obvious demarcation line between the first film layer 631 and the second film layer 632. For example, the first inorganic layer 210 has an opening in the dam 630. The drawing schematically illustrates that the first film layer includes one film layer, but without limiting thereto, the first film layer may also include two film layers such as a portion in the first organic layer and a portion in the second organic layer, e.g., there may be no significant demarcation line between these two film layers.

For example, as shown in Fig. 2 to Fig. 4, the first inorganic layer 210 may have a thickness of 20 to 100 nanometers. For example, the first inorganic layer 210 may have a thickness of 30 to 50 nanometers. For example, the first inorganic layer 210 may have a thickness of 40 to 80 nanometers. For example, the first inorganic layer 210 may have a thickness of 60 to 90 nanometers.

For example, as shown in Fig. 3, the number of the inorganic layer patterns 211 may be 3, the size, in the first direction, of the inorganic layer pattern 211 located in the middle is not greater than the sizes, in the first direction, of the inorganic layer patterns 211 located on both sides. For example, the size, in the first direction, of the inorganic layer pattern 211 located in the middle has a width of about 40 microns, and this width is determined by a spacing between the strip-shaped dams 6300 on both sides. For example, the size, in the first direction, of the inorganic layer pattern 211 furthest away from the display region has a width of about 90 microns, and this width is determined by boundaries of the first organic layer 510 and the second organic layer 520 furthest away from a side of the display region.

For example, as shown in Fig. 2 to Fig. 4, along the direction perpendicular to the base substrate 01, the portion of the inorganic layer pattern 211 that overlaps with the strip-shaped dam 6300 has a size, in the first direction, of 10 to 40 microns. For example, the portion of the inorganic layer pattern 211 that overlaps with the strip-shaped dam 6300 has a size, in the first direction, of 15 to 20 microns. For example, the portion of the inorganic layer pattern 211 that overlaps with the strip-shaped dam 6300 has a size, in the first direction, of 12 to 18 microns. For example, a portion of the edge of the furthermost inorganic layer pattern 211 away from the strip-shaped dam 6300, which overlaps with at least one of the first organic layer 510 and the second organic layer 520, has a size of 10 to 40 microns in the first direction. For example, a portion of the edge of the furthermost inorganic layer pattern 211 away from the strip-shaped dam 6300, which overlaps with at least one of the first organic layer 510 and the second organic layer 520, has a size of 15 to 30 microns in the first direction.

In some examples, as shown in Fig. 2 to Fig. 4, at least one of the plurality of inorganic layer patterns 211 includes a main body portion 2111 extending along the second direction and a widening portion 2112 located on at least one side of the main body portion 2111 in the first direction, in the second direction, the widening portion 2112 has a length smaller than that of the main body portion 2111, in the first direction, the widening portion 2112 has a width smaller than a size of the dam 630, and the widening portion 2112 covers an edge of the power supply signal line 110 that extends along the second direction.

For example, as shown in Fig. 3, the widening portion 2112 may be located only at a location on the edge of the power supply signal line 110 to widen the size of the edge of the power supply signal line 110 covered by the inorganic layer pattern 211, thereby preventing both the inorganic layer pattern 211 and the strip-shaped dam 6300 from exposing the edge of the power supply signal line 110 due to process deviations.

For example, as shown in Fig. 3, the widening portion 2112 may have a width of 5 to 20 microns in the first direction. For example, the widening portion 2112 may have a width of 6 to 15 microns. For example, the widening portion 2112 may have a width of 7 to 10 microns. For example, the widening portion 2112 may have a width of 8 to 12 microns.

For example, as shown in Fig. 4, other structures that are made of conductive materials, such as signal lines made of metal materials, may also be disposed between the conductive structure 100 and the base substrate 01.

For example, as shown in Fig. 2, in the first region 011, no other inorganic layer is disposed between the conductive structure 100 and the first inorganic layer 210. For example, in the first region 011, only the organic layer is disposed between the conductive structure 100 and the first inorganic layer 210. For example, the conductive structure may include a multi-layer conductive structure, such as the above-described first and second conductive structures. In the first region, only the organic layer is disposed between the first conductive structure and the first inorganic layer, and only the organic layer is disposed between the second conductive structure and the first inorganic layer, e.g., the organic layer is disposed between the first conductive structure and the second conductive structure; and in the second region, the second conductive structure is in direct contact with the first inorganic layer, and the first conductive structure is in direct contact with the second conductive structure.

During the research, the inventor of the present application has found that in the second region, when the dam intersects with the extension direction of the power supply signal line included in the conductive structure, the organic layer on the conductive structure at other location than the dam is completely removed to expose the conductive structure at this location, as a result of which the edge of the conductive structure at this location is more susceptible to side etching to form an undercut during subsequent development, and this further leads to significant potential risks such as crack or micro-crack of an encapsulation layer when the surface of the conductive structure is covered by the encapsulation layer, and also brings a higher possibility of occurrence of undesirable GDSX risks at this location in a subsequent trustworthiness environment.

To prevent the above conductive structure from side etching, in the general display substrate, a passivation layer (PVX) is disposed on a side of the conductive structure away from the base substrate, in order to cover the conductive structure not covered by the dam and also protect the side edge of the conductive structure. In this way, the purpose of product reliability validation is realized.

As compared to the general display substrate in which the passivation layer (PVX) is disposed on a side of the conductive structure away from the base substrate, in an example of the embodiment according to the present disclosure, the passivation layer in the general display substrate is replaced with the first inorganic layer. This, on the basis of a compatibility with the film layers of the defining structure in the display region, enables the first inorganic layer to protect, in the second region, the conductive structure exposed by the dam (e.g., the first inorganic layer is in direct contact with the conductive structure), while at the same time saving the mask process for formation of the above passivation layer. Thus, the production capacity for backplane circuits is raised while production costs are saved.

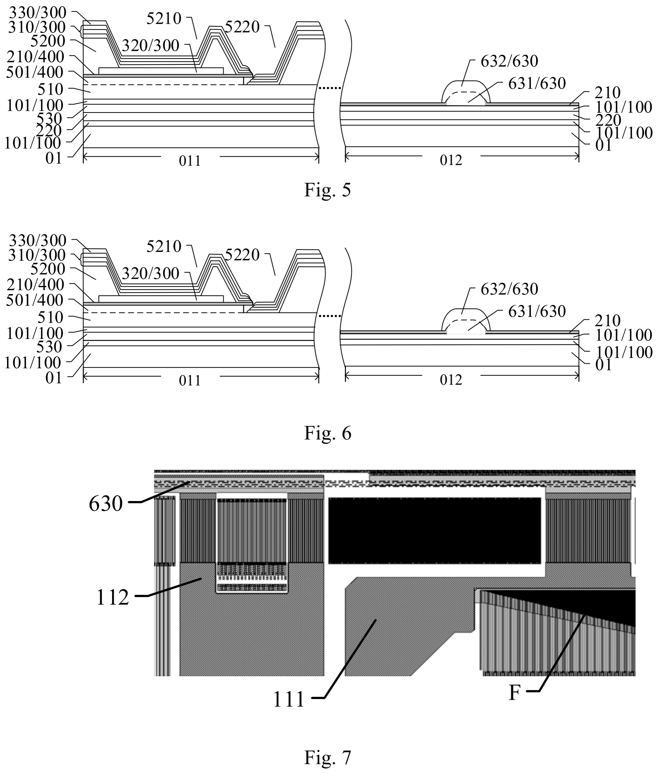

Fig. 5 and Fig. 6 are schematic diagrams of partial sectional structures of the display substrate according to different examples of the embodiments of the present disclosure.

The display substrate shown in Fig. 5 differs from the display substrate shown in Fig. 2 in that there is a different number of structural layers included in the conductive structure 100, and an organic layer and/or an inorganic layer is disposed between different structural layers included in the conductive structure 100.

In some examples, as shown in Fig. 5, the conductive structure 100 includes at least two sub-conductive structures 101 that are stacked; in a part of the first region 011, other organic layers, such as a third organic layer 530, and the second inorganic layer 220 are disposed between two adjacent sub-conductive structures 101 of the at least two sub-conductive structures 101, and in the second region 012, only the second inorganic layer 220 is disposed between the above two adjacent sub-conductive structures 101, with no third organic layer being disposed therebetween. For example, the second inorganic layer 220 may be the passivation layer (PVX). For example, a plurality of inorganic layers, or inorganic layers and other metal layers, may be disposed between the two adjacent sub-conductive structures 101. For example, the second inorganic layer 220 has a thickness greater than that of the first inorganic layer 210. Fig. 5 schematically illustrates two sub-conductive structures 101, but without limiting thereto, there may also be three sub-conductive structures 101, and an organic layer and/or an inorganic layer is disposed between the two adjacent sub-conductive structures.

For example, as shown in Fig. 5, this second inorganic layer 220 may be the passivation layer (PVX) in the above general display substrate. Only the passivation layer (an equivalent of the second inorganic layer 220 shown in Fig. 5) is disposed in the second region 012 in the above general display substrate, and when the first inorganic layer 210 is not disposed, the uppermost sub-conductive structure will be exposed after removal of the organic layer between the adjacent dams 630, and this sub-conductive structure will be patterned and removed in order to prevent it from being side etched, so only the film layers, other than the organic layer, between the second inorganic layer 220 and the base substrate 01 are reserved. In the display substrate provided by the present disclosure, by arranging the first inorganic layer 210 on the side of the sub-conductive structure 100 farthest from the base substrate 01 among the above-mentioned at least two conductive structures 100, the sub-conductive structure 100 farthest from the base substrate 01 in the second region 012 can be retained, which is beneficial to reducing the resistance of the conductive structure 100 located in the second region 012.

The display substrate shown in Fig. 6 differs from the display substrate shown in Fig. 2 in that there is a different number of film layers included in the conductive structure 100, and organic layers are disposed between different film layers included in the conductive structure 100.

In some examples, as shown in Fig. 6, the conductive structure 100 includes at least two sub-conductive structures 100 that are stacked; in the first region 011, other organic layers, such as a third organic layer 530, are disposed between two adjacent sub-conductive structures 100 of the at least two sub-conductive structures 100 and yet, no organic layer is disposed; in the second region 012, the above two adjacent sub-conductive structures 100 are at least partially in direct contact with each other. Compared with a general display substrate, a passivation layer is arranged between the two adjacent sub-conductive structures 100 located in the first region 011, while the first inorganic layer 210 is not arranged on the side of the sub-conductive structure 100 farthest from the base substrate 01, and the conductive structure 100 located in the second area 012 only includes the sub-conductive structure 100 located between the inorganic layer and the base substrate 01 among the two adjacent sub-conductive structures 100. In the display substrate provided by the present disclosure, the passivation layer is omitted between two adjacent sub-conductive structures 100 to reduce one-step patterning process, and the first inorganic layer 210 is arranged on the side of the two adjacent sub-conductive structures 100 away from the base substrate 01 to protect the two adjacent sub-conductive structures 100 located in the second region 012, so that the two adjacent sub-conductive structures 100 are in direct contact, which is beneficial to further reducing the resistance of the conductive structures 100 located in the second region 012.

In some examples, as shown in Fig. 1, the base substrate 01 includes a fourth region 014, the fourth region 014 surrounds a part of the display region, and an orthographic projection, on the base substrate 01, of a portion of the power supply signal line 110 located in the fourth region 014 is completely located inside an orthographic projection of the at least one ring of dams 630 on the base substrate 01. But without limiting thereto, it is possible that an orthographic projection, on the base substrate, of an edge of the power supply signal line located in the fourth region is completely located inside the orthographic projection of the dam on the base substrate. For example, the first region 011 is the display region, and the fourth region 014 and the second region 012 constitute one non-display region that surrounds the display region. For example, the direction indicated by an arrow in direction X is an up direction, the second region 012 is located on a lower side of the display region, and the fourth region 014 is located on upper, left and right sides of the display region. For example, one ring of dam 630 is located in one circle of non-display region composed of the fourth region 014 and the second region 012, the dam 630 located in the fourth region 014 completely covers the power supply signal line 110, the dam 630 located in the second region 012 intersects with the power supply signal line and exposes a part of the power supply signal line 110, and this exposed part of the power supply signal line 110 is covered by the first inorganic layer 210.

In some examples, as shown in Fig. 1 and Fig. 3, in the direction perpendicular to the base substrate 01, a portion of the power supply signal line 110 located in the fourth region 014 does not overlap with the first inorganic layer 210. For example, the power supply signal line 110 in the fourth region 014 is completely covered by the dam 630, and the first inorganic layer 210 is not disposed in the fourth region 014. For example, in one circle of non-display region on the outer side of the display region, the first inorganic layer 210 is disposed only on a lower side (such as lower pad region) where the second region 012 is located.

For example, in the fourth region, in the direction perpendicular to the base substrate, the power supply signal line does not overlap with the first inorganic layer, while in the third region, the edge of the power supply signal line, after being partially covered by the first inorganic layer, is still partially covered by the dam.

In some examples, as shown in Fig. 1 and Fig. 3, the power supply signal line 110 includes a first power supply signal line 111 and a second power supply signal line 112, the fourth region 014 is only provided with the second power supply signal line 112, and the second region 012 is provided with the first power supply signal line 111 and the second power supply signal line 112. For example, the second power supply signal line 112 may be a VSS power supply signal line, and may be connected with a voltage source to output a constant voltage signal, such as a negative voltage signal. For example, the second power supply signal line 112 may also be grounded. For example, the first power supply signal line 111 may be a VDD power supply signal line, and may be connected with a voltage source to output a constant voltage signal, such as a positive voltage signal. For example, the first power supply signal line 111 may further include a portion located in the display region, for electrical connection with the pixel circuit 340 included in the sub-pixel 300 so as to provide a power supply signal. For example, the second power supply signal line 112 is located in the non-display region and disposed to surround the display region, and the second power supply signal line 112 may include a portion located in the display region, for electrical connection with the second electrode 330 included in the sub-pixel 300.

Fig. 7 is a schematic diagram of a partial planar structure of the second region shown in Fig. 1.

For example, as shown in Fig. 1 and Fig. 7, the first power supply signal line 111 and the second power supply signal line 112 are disposed in the second region 012. For example, the second power supply signal line 112 is located on both sides of the first power supply signal line 111 in the second direction. For example, the conductive structure 100 shown in Fig. 3 may be the second power supply signal line 112, but without limiting thereto, it may also be the first power supply signal line 111. For example, the power supply signal line may be electrically connected with pins of a circuit board through contact pads, and the contact pads are located on a side of the dam away from the display region. Fig. 7 schematically illustrates a fan-out F electrically connected with data lines (not shown in the drawing), and the data line is electrically connected with the pixel circuit of the sub-pixels to provide a data signal.

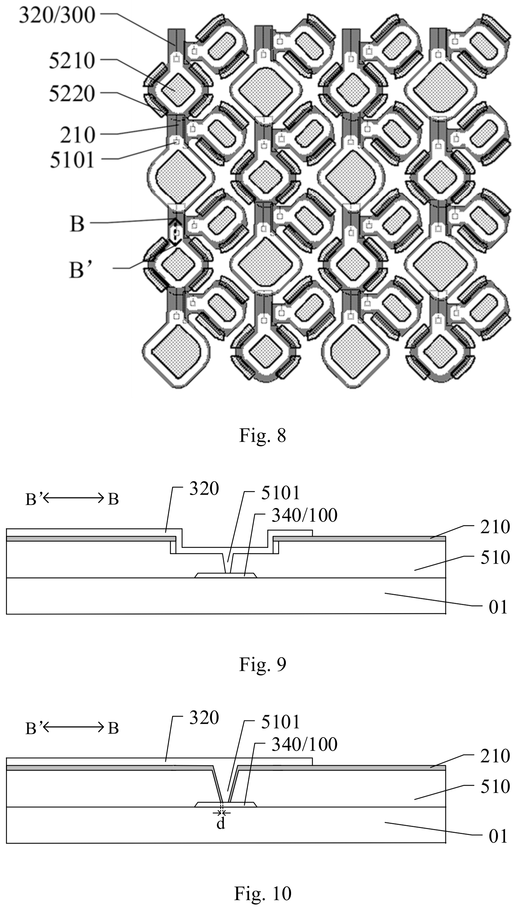

Fig. 8 is a schematic diagram of a pixel arrangement in the display substrate according to an embodiment of the present disclosure. Fig. 9 and Fig. 10 are schematic diagrams of partial sectional structures taken along line BB' shown in Fig. 8, according to different examples of the embodiments of the present disclosure.

For example, as shown in Fig. 8, the sub-pixels 300 may include sub-pixels 300 of different colors, such as red sub-pixels emitting red light, green sub-pixels emitting green light, and blue sub-pixels emitting blue light. The area of the light-emitting region of one blue sub-pixel is greater than the area of the light-emitting region of one red sub-pixel, and the area of the light-emitting region of one red sub-pixel is greater than the area of the light-emitting region of one green sub-pixel. For example, the red sub-pixels and the blue sub-pixels are alternately arranged along the row and column directions, the blue sub-pixels are arranged in an array along the row and column directions, first pixel rows including the red sub-pixels and second pixel rows including the green sub-pixels are alternately disposed along the column direction, and the first pixel rows and the second pixel rows are offset with respect to each other in the row direction. Fig. 8 schematically illustrates a mode of arrangement for a plurality of sub-pixels, but without limiting thereto, the plurality of sub-pixels may also be arranged in other modes.

For example, as shown in Fig. 9 and Fig. 10, the sub-pixel 300 further includes a pixel circuit 340, such as including a plurality of transistors and at least one capacitor. For example, the pixel circuit 340 may be of a structure such as 7T1C, 8T1C, 2T1C, 3T1C, etc., this is not limited in the embodiment of the present disclosure and may be set as actually required by the display substrate. Fig. 9 and Fig. 10 schematically illustrate that the conductive structure 100 is a part of the structure in the pixel circuit 340, but without limiting thereto.

For example, as shown in Fig. 9 and Fig. 10, both the first inorganic layer 210 and the first organic layer 510 are located between the first electrode 320 of the sub-pixel 300 and the base substrate 01, the first organic layer 510 includes a via hole 5101 such as anode via hole 5101, and the first electrode 320 of the sub-pixel 300 is electrically connected with the pixel circuit 340 through the via hole 5101. For example, the first inorganic layer 210 includes a hole exposing the above via hole 5101 in the first organic layer 510, so as to create a hole nesting design.

The inventor of the present application has found during the research that as shown in Fig. 9, similar to the structural features in the above defining structure 400, an edge of the first inorganic layer 210 located on an edge of the anode via hole 5101 protrudes relative to an edge of the first organic layer 510, therefore, the first electrode 320 of the sub-pixel 300 is easy to break during the electrical connection with the pixel circuit 340, such as the conductive structure 100, through the nested hole formed by the first inorganic layer 210 and the first organic layer 510, thus causing the display substrate to appear mura or pixel dark spots when used for display.

In some examples, as shown in Fig. 10, the first inorganic layer 210 covers at least a part of an inner wall of the above anode via hole 5101 in the first organic layer 510, in order to avoid the crack issue during electrical connection of the first electrode 320 of the sub-pixel 300 with the pixel circuit 340. For example, the first inorganic layer 210 wraps the anode via hole 5101 in the first organic layer 510, the anode via hole 5101 is formed on a surface originally exposed by the first inorganic layer 210, as shown in Fig. 9.

For example, Fig. 10 schematically illustrates that the first inorganic layer 210 may cover the entire inner wall of the anode via hole 5101. At this moment, loss generated by etching may not occur at the location where the first organic layer 510 is in contact with the first inorganic layer 210, but without limiting thereto, the first inorganic layer 210 may cover a part of the inner wall of the anode via hole 5101 away from the base substrate 01.

For example, as shown in Fig. 10, a portion of a sidewall of the first inorganic layer 210 located in the anode via hole 5101 has a size of d, such as a thickness greater than 1 micron. For example, as compared to the general display substrate in which the anode via hole in the first organic layer has a size of *a* when the first inorganic layer does not cover the inner wall of the anode via hole, the anode via hole, the inner wall of which is covered by the first inorganic layer, in the first organic layer in the embodiment of the present disclosure has a size that is greater than a. For example, the anode via hole, the inner wall of which is covered by the first inorganic layer, in the first organic layer may have a size of 2 to 3 microns.

Fig. 9 and Fig. 10 only schematically illustrate the structures between the first electrode 320 of the sub-pixel 300 and the base substrate 01, and that structures, such as the light-emitting functional layer 310, the second electrode 330, the pixel defining pattern 5200, etc. shown in Fig. 2, are also disposed on a side of the first electrode 320 away from the base substrate 01.

For example, the first inorganic layer and one insulating layer such as the first organic layer that is in direct contact with the first inorganic layer may be disposed in the first region, one region of the first region may be provided with only the first inorganic layer, such as in the anode via hole shown in Fig. 10, and another region of the first region may be provided with only the first organic layer, such as between adjacent sub-pixels.

In some examples, as shown in Fig. 1, the base substrate 01 further includes a third region, 013, and the third region 013 includes a part of the non-display region. For example, the first region 011 surrounds the third region 013. For example, the third region 013 includes a transparent region and a non-transparent region. The transparent region is used to set up light-sensitive sensors, such as infrared sensor, ultrasonic sensor, LIDAR (Light Detection and Ranging) sensor, radar sensor, camera, and distance sensor, but without limiting thereto; the non-transparent region surrounds the transparent region. For example, the third region 013 may also be referred to as an AA hole region.

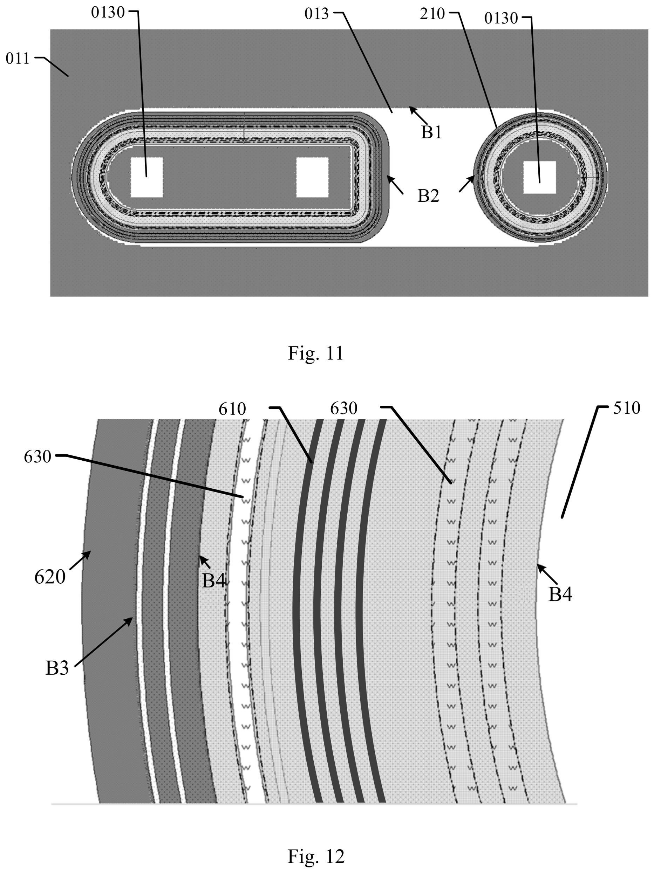

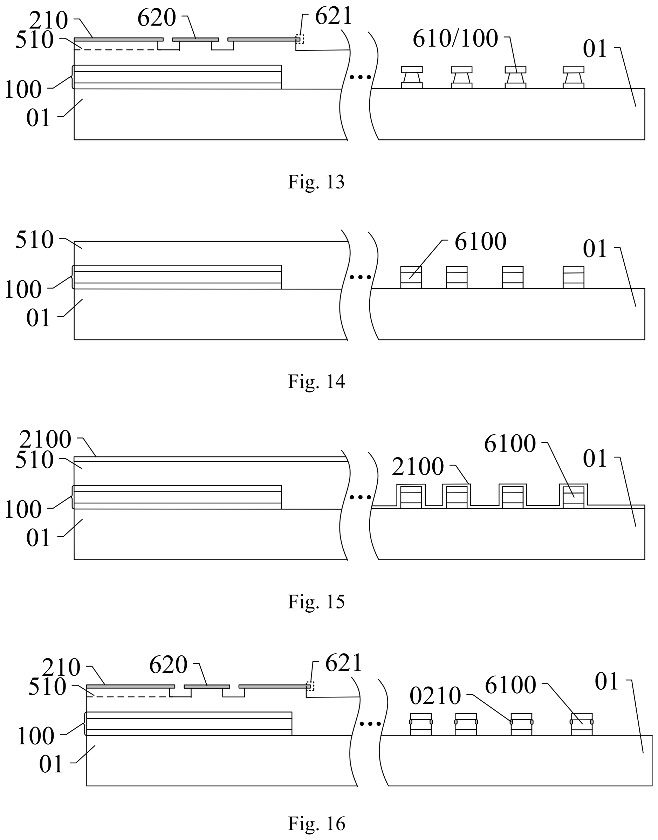

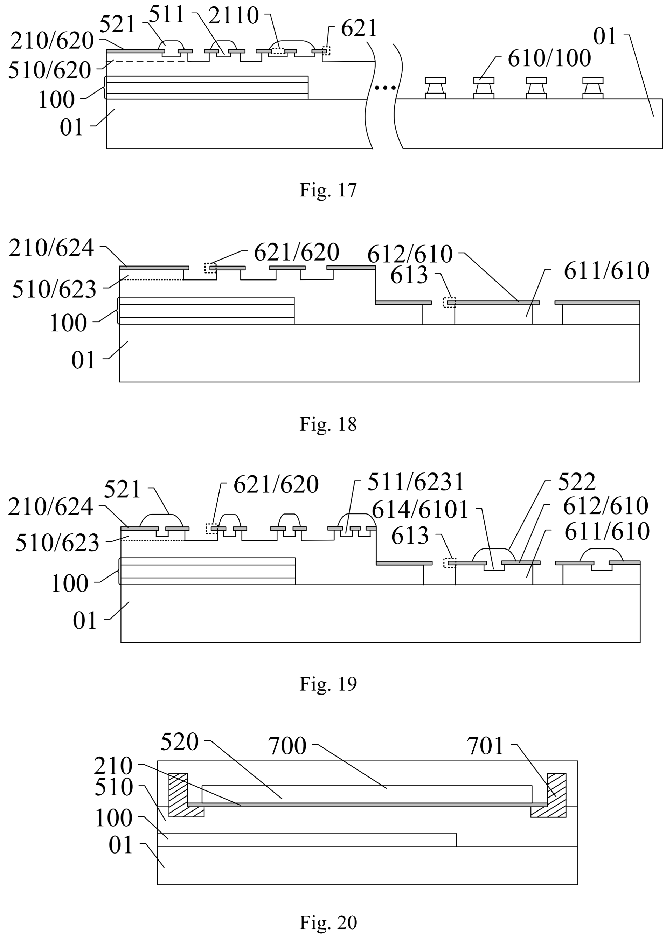

Fig. 11 is a schematic diagram of a planar structure of the first region and the third region of the display substrate shown in Fig. 1. Fig. 12 is a schematic diagram of a partial planar structure of the third region shown in Fig. 11. Fig. 13 is a schematic diagram of a partial sectional structure of the display substrate shown in Fig. 12 in an example. The structure shown in Fig. 12 may be a partial structure on the leftmost side shown in Fig. 11. In Fig. 13 and Fig. 17, the dam between a first isolation column and a second isolation column is omitted.

In some examples, as shown in Fig. 11 to Fig. 13, a portion of the conductive structure 100 located in the third region 013 includes at least one ring-shaped first isolation column 610, and the first isolation column 610 does not overlap with the first organic layer 510 in the direction perpendicular to the base substrate 01. For example, the first isolation column 610 does not overlap with the first inorganic layer 210 in the direction perpendicular to the base substrate 01. But without limiting thereto, for example, the first inorganic layer may wrap up a sidewall of the first isolation column, avoiding the issues caused by water and oxygen invasion due to a connection between a cracked cathode and a metal layer included in the first isolation column.

For example, Fig. 12 and Fig. 13 schematically illustrate that the portion of the conductive structure 100 located in the third region 013 includes four circles of first isolation columns 610, e.g., a plurality of first isolation columns 610 may be arranged equidistantly. But without limiting thereto, the number of the first isolation columns may also be one circle, two circles, three circles, etc. For example, the conductive structure 100 may include at least one layer of the sub-conductive structure, in which one layer of the sub-conductive structure includes the first isolation column 610.

For example, as shown in Fig. 11, the third region 013 may include a plurality of transparent regions 0130, such as three transparent regions 0130, but without limiting thereto, the third region 013 may also include one transparent region 0130. For example, one circle of first isolation column 610 may surround at least one transparent region 0130. For example, different first isolation columns 610 may surround the same transparent region 0130, and may also surround different transparent regions 0130.

In some examples, as shown in Fig. 11 to Fig. 13, at least a part of an edge of the first region 011 close to the third region 013 or at least a part of an edge of the third region 013 close to the first region 011 includes a second isolation column 620. For example, the second isolation column 620 is disposed on a part of the edge of the third region 013 close to the first region 011. For example, the third region 013 is further provided with at least one ring of dams 630, and this dam 630 plays the same role as the dam 630 shown in Fig. 3.

For example, B1 shown in Fig. 11 indicates the boundary of the light-emitting layer formed using a Fine Metal Mask (FMM), in the light-emitting functional layer 310, B2 indicates the boundary of the first inorganic layer 210 located in the third region 013, other shared film layers in the light-emitting functional layer 310 cover the third region 013 as a whole, and the second electrode 330 of the sub-pixel 300 covers the third region 013 as a whole. For example, B3 shown in Fig. 12 indicates the boundary of the second organic layer 520, B4 indicates the boundary of the first organic layer 510, e.g., between two B4 boundaries, only one dam 630 closest to the second isolation column 620 is provided with the first organic layer 510.

For example, when only one transparent region 0130 is disposed in the third region 013, the second isolation column 620 may be disposed on all the edges of the third region 013 close to the first region 011, e.g. the second isolation column 620 surrounds the first isolation column 610. For example, when a plurality of transparent regions 0130 are disposed in the third region 013, the second isolation column 620 is disposed not only on the edge of the third region 013 close to the first region, but also between two adjacent transparent regions 0130, and each transparent region 0130 is surrounded by the second isolation column 620.

In some examples, as shown in Fig. 13, the second isolation column 620 includes a stacked structure formed by the first inorganic layer 210 and the first organic layer 510, and in the second isolation column 620, an edge of the first inorganic layer 210 includes a first protrusion 621 that protrudes relative to at least a part of the edge of the first organic layer 510. The first isolation column 610 and the second isolation column 620 are configured to disconnect the light-emitting functional layer 310 and the second electrode 330, or the first isolation column 610 and the second isolation column 620 are configured to disconnect the light-emitting functional layer 310.

Fig. 14 to Fig. 16 are diagrams illustrating process steps for formation of the display substrate shown in Fig. 13.

For example, as shown in Fig. 14, after a pre-isolation column 6100 disposed in the same layer as the power supply signal line 110 is formed by patterning, a first organic material layer that covers the pre-isolation column 6100 is formed and then patterned to form the first organic layer 510, and the process of patterning the first organic material layer includes removing the first organic material layer that covers the surface of the pre-isolation column 6100 and forming the anode via hole 5101 shown in Fig. 10. The above-described pre-isolation column 6100 is a structure prior to etching formation of the first isolation column 610, various film layers (such as various film layers in a three-layer structure, and the three-layer structure may include a titanium/aluminum/titanium structure) in this pre-isolation column 6100 have edges that are substantially flush with each other, without including the protrusion for disconnecting the light-emitting functional layer 310 or the second electrode 330.

For example, as shown in Fig. 15, a first inorganic material layer 2100 is formed on the pre-isolation column 6100 and the first organic layer 510, and this first inorganic material layer 2100 may be a whole film layer.

For example, as shown in Fig. 16, the first inorganic material layer 2100 is patterned to form the defining structure 400 located in the first region 011 and the second isolation column 620 located on the edge of the third region 013. In the process of patterning the first inorganic material layer 2100, the first organic layer 510 that is in contact with the surface of the first inorganic material layer 2100 will be etched to a certain extent to generate a particular loss, such that an undercut is formed at the location where the first organic layer 510 is in contact with the first inorganic layer 210, and a portion of the first inorganic layer 210 that protrudes relative to the first organic layer 510 is the protrusion.

During the research, the inventor of the present application has found that in the display substrate having the first inorganic layer 210 disposed therein and in a dry-etching process of removing the first organic material layer on the pre-isolation column by means of patterning, the sidewall of the pre-isolation column will be side-etched to a certain extent, such that during removal of the first inorganic material layer on the pre-isolation column, an inorganic material 0210 will partially remain at the side-etched location of the sidewall of the pre-isolation column, making it impossible to form the first isolation column 610 having an undercut appearance shown in Fig. 13. As a result, a one-step etching process needs to be added to remove the inorganic material that remains on the sidewall of the pre-isolation column. For example, in the process of etching formation of the first electrode 320 subsequent to formation of the first inorganic layer 210, the pre-isolation column may be etched to form the first isolation column 610.

For example, as shown in Fig. 11 to Fig. 13, while the first isolation column 610 formed by the conductive structure 100 is disposed in the third region 013, the second isolation column 620 that is formed by stacking up the first inorganic layer 210 and the first organic layer 510 is disposed, thus facilitating further isolating the shared film layers in the light-emitting functional layer 310 between the third region 013 and the first region 011 as well as for the second electrode 330 disposed on the whole surface and shared by the plurality of sub-pixels 300. In this way, reliability validation for the AA hole region can be better ensured in the trustworthiness process.

Fig. 17 is a schematic diagram of a partial sectional structure of the display substrate shown in Fig. 12 in another example. The sectional structure of the display substrate shown in Fig. 17 differs from the sectional structure of the display substrate shown in Fig. 13 in that the second isolation column 620 has a different structure.

In some examples, as shown in Fig. 17, in at least one second isolation column 620, the first organic layer 510 is provided with a first groove 511 and the first inorganic layer 210 includes an opening 2110 exposing the first groove 511; the second organic layer 520 includes a first covering portion 521, and the first covering portion 521 covers the first groove 511 and an edge of the first inorganic layer 210 close to the first groove 511.

In the display substrate according to the present disclosure, while the opening is disposed in the first inorganic layer included in the second isolation column, the first covering portion is utilized to cover the edge of the opening in the first inorganic layer, which not only helps accomplish outgassing for the first organic layer, but can also avoid the peeling issue that results from a weak adhesion of the first inorganic layer and the first organic layer in the second isolation column.

For example, as shown in Fig. 17, one opening 2110, or a plurality of openings 2110, may be disposed in the same second isolation column 620. For example, the opening 2110 may have a closed annular shape for surrounding the transparent region. For example, the opening 2110 may have a non-closed annular shape, e.g., this non-closed annular shape may include a plurality of small openings disposed at intervals. For example, the openings 2110 disposed in different second isolation columns 620 may have the same or different shapes. For example, when the openings 2110 disposed in different second isolation columns 620 have the closed annular shape, different openings 2110 located in different second isolation columns 620 may have the same or different widths.

For example, as shown in Fig. 17, the opening 2110 included in the first inorganic layer 210 and exposing the first groove 511 may have a dimension same as or different than that of the first groove 511, e.g., the size of the opening 2110 is smaller than the size of the first groove 511.

For example, as shown in Fig. 17, in the direction perpendicular to the base substrate 01, the first covering portion 521 does not overlap with the first protrusion 621. For example, in the direction perpendicular to the base substrate 01, the first covering portion 521 does not overlap with a spacing between adjacent second isolation columns 620.

For example, as shown in Fig. 17, the minimum distance between a surface of the first organic layer 510 away from the base substrate 01 and a surface of the conductive structure 100 away from the base substrate 01 is 1.7 to 1.9 microns, such as 1.8 microns. For example, the maximum thickness of the first organic layer 510 right above the conductive structure 100 is 2 to 2.2 microns, such as 2.1 microns.

For example, as shown in Fig. 17, the first organic layers 510 included in the plurality of second isolation columns 620 may be of an integral structure, and the first organic layers 510 included in the plurality of second isolation columns 620 include portions that are separated from each other.

Fig. 18 and Fig. 19 are schematic diagrams of partial sectional structures of the third region of the display substrate shown in Fig. 1 in different examples. The sectional structures of the display substrate shown in Fig. 18 and Fig. 19 differ from the sectional structure of the display substrate shown in Fig. 13 in that the first isolation columns 610 have different structures.

In some examples, as shown in Fig. 18, the first isolation column 610 includes a first isolation layer 611 and a second isolation layer 612 that are stacked, and the second isolation layer 612 is located on a side of the first isolation layer 611 away from the base substrate 01; a portion of the first organic layer 510 located in the third region 013 includes the first isolation layer 611, a portion of the first inorganic layer 210 located in the third region 013 includes the second isolation layer 612, and the second isolation layer 612 is disposed to protrude relative to an edge of the first isolation layer 611 in order to form a second protrusion 613. For example, as shown in Fig. 18, the first isolation column 610 and the second isolation column 620 are both located in the third region 013.

As compared to formation of the first isolation column 610 by using the conductive structure 100 as shown in Fig. 13 to Fig. 17, in this example, the first inorganic layer 210 is used to replace the original passivation layer to save one-step mask (such as PVX mask), and the first isolation column 610 formed by the stacked first inorganic layer 210 and the first organic layer 510 is used to replace the first isolation column 610 formed by the conductive structure 100, so that the problem that the first inorganic layer 210 is easy to remain on the first isolation column 610 can be avoided, and thus one-step mask process, such as Hole mask, can be further saved.

For example, as shown in Fig. 18, the maximum distance between a surface of the first organic layer 510 located right above the conductive structure 100, away from the base substrate 01, and a surface of the conductive structure 100 away from the base substrate 01 is 2 to 2.2 microns, such as 2.1 microns. For example, the minimum distance between the surface of the first organic layer 510 located right above the conductive structure 100, away from the base substrate 01, and the surface of the conductive structure 100 away from the base substrate 01 is 1.7 to 1.9 microns, such as 1.8 microns. For example, the portion in the first organic layer 510, which serves as the second isolation column 620, may have a thickness of 0.2 to 0.4 microns, such as 0.3 microns.

For example, as shown in Fig. 18, the first isolation layer 611 may have a thickness of 2 to 2.2 microns, such as 2.1 microns.

For example, as shown in Fig. 18, the first isolation layer 611 of one first isolation column 610, closest to the second isolation column 620, of the plurality of first isolation columns 610, and the first organic layer 510 may be of an integral structure. For example, the distance between the second isolation layer 612 of one first isolation column 610, closest to the second isolation column 620, of the plurality of first isolation columns 610, and the conductive structure 100 may be 3.9 to 4.1 microns, such as 4 microns. For example, the distance between second isolation layers 612 in adjacent first isolation column 610 may be 9.5 to 10 microns, such as 10 microns.

For example, in other examples, with reference to Fig. 18, a third organic layer is further disposed between the first organic layer 510 and the base substrate 01, a portion of the third organic layer located in the third region 013 includes the first isolation layer 611, a portion of the first inorganic layer 210 located in the third region 013 includes the second isolation layer 612, and the second isolation layer 612 is disposed to protrude relative to an edge of the first isolation layer 611 to form a second protrusion 613. In this example, the third organic layer between the first organic layer 510 in the second isolation column 620 and the base substrate 01 has been removed, and the first isolation column 610 uses an organic layer different from that in the second isolation column 620, as the first isolation layer 611. For example, the materials of the first organic layer and the third organic layer may be the same. For example, the thickness of the first isolation layer 611 when the third organic layer serves as the first isolation layer 611 is smaller than the thickness of the first isolation layer 611 when the first organic layer 510 serves as the first isolation layer 611, e.g., when the third organic layer serves as the first isolation layer 611, the first isolation layer 611 may have a thickness of 1.4 to 1.6 microns, such as 1.5 microns, or a thickness of 0.7 to 0.9 microns, such as 0.8 microns.

In some examples, as shown in Fig. 19, a side of the first isolation layer 611 away from the base substrate 01 is provided with a second groove 614, and the second isolation layer 612 exposes the second groove 614; the display substrate further includes a second organic layer 520 located on a side of the first inorganic layer 210 away from the base substrate 91, the second organic layer 520 includes a second covering portion 522, and the second covering portion 522 at least covers the second groove 614.

In the display substrate according to the present disclosure, while the second groove is disposed in the first isolation layer included in the first isolation column, the second covering portion is utilized to cover the second groove and the edge of the second isolation layer close to the second groove, which not only helps accomplish outgassing for the first isolation layer, but can also avoid the peeling issue that results from a weak adhesion of the first isolation layer and the second isolation layer in the first isolation column.

For example, Fig. 19 schematically illustrates that while the first isolation column 610 is covered by the second covering portion 522, the second isolation column 620 is covered by the first covering portion 521, which can accomplish outgassing for the organic layers in the first isolation column 610 and the second isolation column 620, while at the same time preventing the inorganic layers in the first isolation column 610 and the second isolation column 620 from peeling. Certainly, the embodiment of the present disclosure is not limited thereto, the second isolation column 620 may also be as shown in Fig. 18 while the first isolation column 610 is covered by the second covering portion 522.

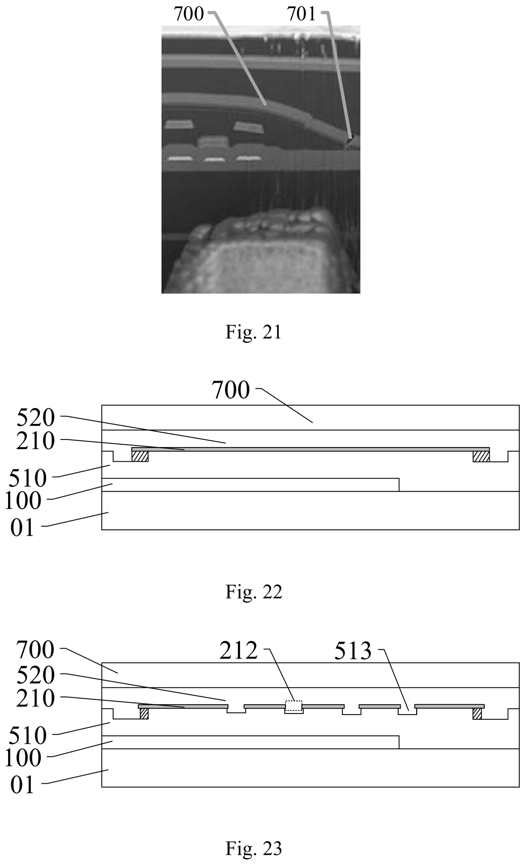

Fig. 20 is a schematic diagram illustrating a crack of an encapsulation layer at the boundary of a first inorganic layer. Fig. 21 is a scanning electron microscope image illustrating the crack of the encapsulation layer at the boundary of the first inorganic layer. The structure shown in Fig. 20 may be located at a location, close to the first region 011, of the first isolation column 610 in the third region 013, and may also be located on an edge of the second region 012 away from the first region 011.

For example, as shown in Fig. 20 and Fig. 21, etching on the edge of the first inorganic layer 210 will lead to a loss in the first organic layer 510 below the first inorganic layer 210, such that the first inorganic layer 210 includes a protrusion that protrudes relative to a part of the edge of the second inorganic layer 220, and a portion of the first inorganic layer 210 that protrudes relative to the first organic layer 510 is not covered by the second organic layer 520. When the encapsulation layer 700 is deposited on the edge of the first inorganic layer 210, a crack is highly likely to occur to create a cracking region 701.

Fig. 22 and Fig. 23 are structural diagrams in different examples of the embodiments of the present disclosure, at a location of Fig. 20.

In some examples, as shown in Fig. 12 and Fig. 22, the encapsulation layer 700 is located on a side of the second organic layer 520 away from the base substrate 01, an edge furthest away from the first region 011 in a portion of the first inorganic layer 210 covering the first organic layer 510 and protruding relative to an edge of the first organic layer 510 is covered by the second organic layer 520, and the encapsulation layer 700 covers the edge of the second organic layer 520. For example, the second isolation column 620 located in the third region 013 is formed by stacking up the first organic layer 510 and the first inorganic layer 210 shown in Fig. 22.

In some examples, as shown in Fig. 3 and Fig. 22, the encapsulation layer 700 is located on a side of the second organic layer 520 away from the base substrate 01, an edge furthest away from the first region 011 in a portion of the first inorganic layer 210 covering the first organic layer 510 and protruding relative to an edge of the first organic layer 510 is covered by the second organic layer 520, and the encapsulation layer 700 covers the edge of the second organic layer 520. For example, the second organic layer 520 shown in Fig. 22 may be a part of the dam 630.

For example, the encapsulation layer 700 may include a plurality of film layers that are stacked, such as an inorganic encapsulation layer, an organic encapsulation layer and an inorganic encapsulation layer that are stacked in sequence.

In the display substrate according to the present disclosure, the part of the first inorganic layer protruding relative to the edge of the first organic layer is covered by the second organic layer, it is possible to prevent the encapsulation layer from cracking at the part of the first inorganic layer protruding relative to the edge of the first organic layer.

In some examples, as shown in Fig. 23, the first inorganic layer 210 includes a plurality of notches 212 exposing the first organic layer 510, and the second organic layer 520 fills the plurality of notches 212. For example, the first organic layer 510 includes a plurality of recesses 513, the first inorganic layer 210 includes a plurality of notches 212 exposing the plurality of recesses 513, and the second organic layer 520 fills the plurality of recesses 513.

During the research, the inventor of the present application has found that when a first organic layer having a large area is disposed between the first inorganic layer and the base substrate in the display substrate, it is bad for outgassing for the first organic layer on one hand; and on the other hand, the presence of a weak adhesion between the first inorganic layer and the first organic layer easily leads to the peeling issue in the first inorganic layer. In the display substrate as shown in Fig. 23 according to the present disclosure, with the notches being disposed in the first inorganic layer on the first organic layer having a large area of coverage so as to expose a part of the first organic layer, outgassing for the first organic layer is facilitated; in the meantime, the second organic layer, which is located on a side of the first inorganic layer away from the first organic layer, fills the notches of the first inorganic layer, thus enabling the adhesion of the first organic layer and the second organic layer to solve the peeling issue that easily occurs in the first inorganic layer.

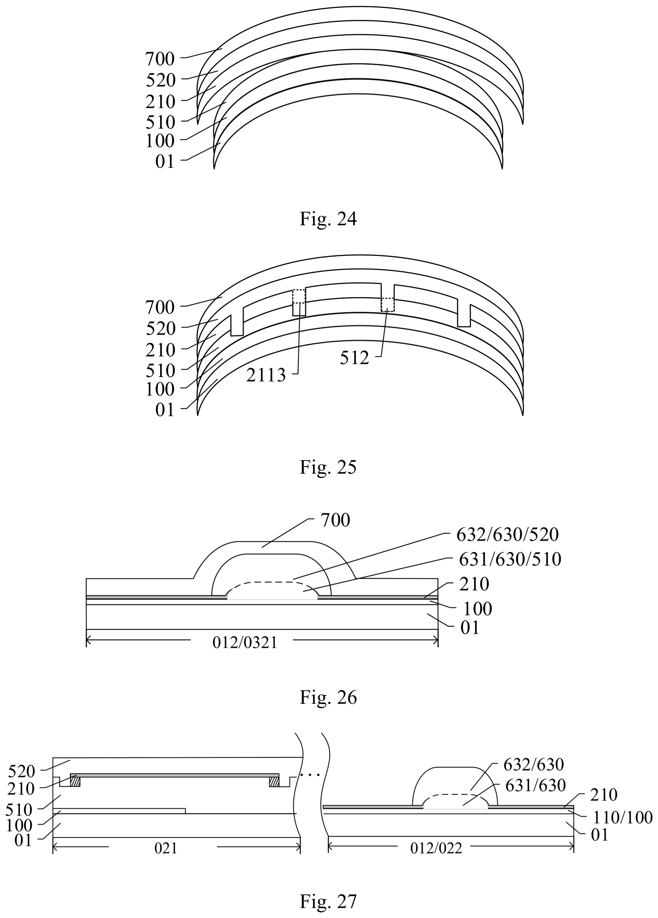

Fig. 24 and Fig. 25 are schematic diagrams of partial structures of a bending region in the display substrate shown in Fig. 1, in different examples.

In some examples, as shown in Fig. 1, Fig. 24 and Fig. 25, the base substrate 01 includes a bending region 015, the display substrate includes a base substrate 01, a conductive structure 100, a first organic layer 510, a first inorganic layer 210, a second organic layer 520 and an encapsulation layer 700 that are stacked, and portions of the conductive structure 100, the first inorganic layer 210, the first organic layer 510 and the second organic layer 520 located in the bending region 015 are all configured to be bendable. For example, the bending region 015 may overlap with a part of the second region 012. Fig. 24 and Fig. 25 schematically illustrate the appearance of the structures in the bending region in a bending state, but without limiting thereto, the structures in the bending region may also be in a non-bending state.

During the research, the inventor of the present application has found that as for some large and medium-sized display devices or display devices applied to mobile phones, a foldable design is employed in their bending regions, and when the first inorganic layer 210 having a relatively large area is disposed in the bending region 015 and the display device is bent in the bending region 015, the peeling phenomenon as shown in Fig. 24 easily occurs at least between the first inorganic layer 210 and the first organic layer 510 because stresses cannot be released, e.g., the peeling phenomenon similar to that shown in Fig. 24 also easily occurs between the first inorganic layer 210 and the second organic layer 520.

In some examples, as shown in Fig. 25, a portion of the first inorganic layer 210 located in the bending region 015 includes a hole 2113, a portion of the first organic layer 510 located in the bending region 015 includes a third groove 512, and the second organic layer 520 fills the hole 2113 and the third groove 512.

In the display substrate according to the present disclosure, the first inorganic layer inside the bending region is patterned to include a plurality of holes exposing the first organic layer and the second organic layer is in contact with the first organic layer through the plurality of holes, such that the organic layers located on both sides of the first inorganic layer are adhered through the plurality of holes. While realizing that the first organic layer releases water vapor and reduces the peeling probability of the first inorganic layer, it is also beneficial to release the bending force through the opening to improve the reliable folding effect of the flexible display substrate.

For example, as shown in Fig. 25, the bending region 015 may be within a range of 3 millimeters from both sides of a bending line of the display substrate. For example, an orthographic projection of the hole 2113 on the base substrate 01 may have a regular shape such as circular shape, oval shape, rectangular shape, long-strip shape, etc., and may also have an irregular shape. For example, the plurality of holes 2113 are evenly disposed.

In the above display substrate according to the present disclosure, the first inorganic layer in different regions may be patterned in different ways, such that between adjacent dams in the non-display region, the original passivation layer covering the power supply signal line is replaced, while at the same time reducing crosstalk by isolating, inside the display region, at least one layer in the light-emitting functional layer of the sub-pixels disposed adjacently and having different colors, so on the basis that the one-step patterning process and costs are reduced, the effect of the passivation layer can be achieved so as to solve the growing dark spot (GDS) issue in the reliability validation process for this region and also to facilitate an increase in product yield and quality control; and/or, the second isolation column that is formed by stacking up the first inorganic layer and the first organic layer is additionally disposed at a location in the non-display region other than the location of the first isolation column formed by the conductive structure, in order to further disconnect the shared film layers in the light-emitting functional layer and the second electrode of the sub-pixels, help promote the power outage effect of the isolation columns in the non-display region, and alleviate the growing dark spot (GDS) issue that easily occurs in the trustworthiness process for this location; and/or, the original first isolation column formed by the conductive structure is replaced with the first isolation column formed by stacking up the first inorganic layer and the first organic layer or other organic layers, thereby saving the patterning process for one-step removal of the inorganic material that remains on the sidewall of the pre-isolation column formed by the conductive structure; and/or, the hole exposing the first organic layer is disposed in the first inorganic layer to accomplish outgassing and simultaneously prevent the first inorganic layer from peeling; and/or, the portion of the first inorganic layer that protrudes relative to the edge of the first organic layer is covered by the second organic layer, in order to prevent the crack of the encapsulation layer on the edge of this first organic layer; and/or, the first inorganic layer covers the inner wall of the anode via hole formed in the first organic layer, in order to avoid the dark pixel spot or mura phenomenon caused by the crack of the first electrode (such as anode) on the edge of this anode via hole.

Provided in the embodiment of the present disclosure is another display substrate, which, as shown in Fig. 1 to Fig. 7, includes a base substrate 01, an inorganic layer 210, a conductive structure, and at least one ring of dams 630 located on the base substrate 01. The base substrate 01 includes a display region 031 and a non-display region 032 surrounding the display region 031; the inorganic layer 210 is located in the display region 031 and the non-display region 032 of the base substrate 01; the conductive structure 100 is located between the inorganic layer 210 and the base substrate 01, and the conductive structure 100 includes a power supply signal line 110; at least one ring of dams 630 is located in the non-display region 032 and surrounds the display region 031, and the dam 630 is located on a side of the conductive structure 100 away from the base substrate 01. The inorganic layer 210, the conductive structure 100 and the dam 630 in the display substrate according to this embodiment may have the same features as the first inorganic layer 210, the conductive structure 100 and the dam 630 in the display substrate according to the above-mentioned embodiment.

With reference to Fig. 1 to Fig. 7, the non-display region 032 includes a first non-display region 0321 located on a side of the display region 031, a portion of the power supply signal line 110 located in the first non-display region 0321 extends along a first direction, a portion of the dam 630 located in the first non-display region 0321 includes a strip-shaped dam 6300 extending along a second direction and overlapping with the power supply signal line 110, a portion of the inorganic layer 210 located in the first non-display region 0321 includes an inorganic layer pattern 211 extending along the second direction, and along a direction perpendicular to the base substrate 01, an edge of the strip-shaped dam 6300 overlaps with at least a part of an edge of the inorganic layer pattern 211. For example, along the direction perpendicular to the base substrate 01, the edge of the strip-shaped dam 6300 overlaps completely with the edge of the inorganic layer pattern 211. The first direction and the second direction in this embodiment may have the same features as the first direction and the second direction in the above-mentioned embodiment, respectively. The inorganic layer pattern 211, the strip-shaped dam 6300 and the relationship of overlapping of the both in the display substrate according to this embodiment may be the same as the inorganic layer pattern 211, the strip-shaped dam 6300 and the relationship of overlapping of the both in the display substrate according to the above embodiment. The display region 031 and the first non-display region 0321 in the display substrate according to this embodiment may be the first region 011 and the second region 012 in the display substrate according to the above embodiment, respectively.

In the display substrate according to the present disclosure, the inorganic layer including the inorganic layer pattern is disposed in the first non-display region where the extension direction of the power supply signal line and the extension direction of the strip-shaped dam intersect, it is beneficial to cover the edge of the power supply signal line to prevent the edge of the power signal line from being etched and other defects.

For example, the inorganic layer according to the present disclosure can replace the passivation layer in the above-described display substrate, saving the one-step patterning process.

In some examples, with reference to Fig. 1 to Fig. 7, the non-display region 032 includes a second non-display region 0322 surrounding the display region 031, an orthographic projection, on the base substrate 01, of a portion of the power supply signal line 110 located in the second non-display region 0322 is completely located inside an orthographic projection of the at least one ring of dams 630 on the base substrate 01. The second non-display region 0322 in this embodiment may be the fourth region 014 in the above embodiment, and the relationship between the portion of the power supply signal line 110 located in the second non-display region 0322 and the dam 630 in the display substrate according to this embodiment may be the same as the relationship between the portion of the power supply signal line 110 located in the fourth region 014 and the dam 630 in the display substrate according to the above embodiment.

In some examples, with reference to Fig. 1 to Fig. 7, in the direction perpendicular to the base substrate 01, a portion of the power supply signal line 110 located in the second non-display region 0322 does not overlap with the inorganic layer 210. The relationship of overlapping of the portion of the power supply signal line 110 located in the second non-display region 0322 with the inorganic layer 210 in the display substrate according to this embodiment may be the same as the relationship of overlapping of the portion of the power supply signal line 110 located in the fourth region 014 with the first inorganic layer 210 in the display substrate according to the above embodiment.

In some examples, with reference to Fig. 1 to Fig. 7, the power supply signal line 110 includes a first power supply signal line 111 and a second power supply signal line 112, the second non-display region 0322 is only provided with the second power supply signal line 112, and first non-display region 0321 is provided with the first power supply signal line 111 and the second power supply signal line 112. The first power supply signal line 111 and the second power supply signal line 112 in this embodiment may have the same features as the first power supply signal line 111 and the second power supply signal line 112 in the above embodiment. The location distribution features of the first power supply signal line 111 and the second power supply signal line 112 in the first non-display region 0321 and the second non-display region 0322 in the display substrate according to this embodiment may be the same as the location distribution features of the first power supply signal line 111 and the second power supply signal line 112 in the second region 012 and the fourth region 014 in the display substrate according to the above embodiment.

In some examples, with reference to Fig. 1 to Fig. 7, at least one inorganic layer pattern 211 includes a plurality of inorganic layer patterns 211, the number of the strip-shaped dams 6300 is at least one, and the strip-shaped dam 6300 and the plurality of inorganic layer patterns 211 are alternately disposed along the first direction. The relationship where the inorganic layer patterns 211 and the strip-shaped dam 6300 are alternately disposed in the display substrate according to this embodiment may be the same as the relationship where the inorganic layer patterns 211 and the strip-shaped dam 6300 are alternately disposed in the display substrate according to the above embodiment. For example, the inorganic layer pattern in the display substrate according to this embodiment may have the same shape and size as those of the inorganic layer pattern in the display substrate according to the above embodiment.

In some examples, with reference to Fig. 1 to Fig. 7, the inorganic layer pattern 211 covers an edge of the power supply signal line 110 that extends along the first direction. The relationship of the inorganic layer pattern 211 covering the edge of the power signal line 110 in the display substrate provided by this embodiment can be the same as the relationship of the inorganic layer pattern 211 covering the edge of the power signal line 110 of the display substrate provided by the above embodiment.

In some examples, with reference to Fig. 1 to Fig. 7, the display substrate further includes a first organic layer 510 located between the inorganic layer and the base substrate 01, a portion of the first organic layer 510 located in the display region including a planar layer (PLN), a portion of the first organic layer 510 located in the non-display region 032 includes a first film layer 631 of the dam 630, and a portion of the inorganic layer 210 that overlaps with the dam 630 in the direction perpendicular to the base substrate 01 covers an edge of the first film layer 631. The planar layer of the first organic layer 510 located in the display region 031 and the first film layer 631 of the dam 630 in the non-display region 032 in the display substrate according to this embodiment have the same features as the planar layer of the first organic layer 510 located in the first region 011 and the first film layer 631 of the dam 630 located in the second region 012 in the display substrate according to the above embodiment, respectively.

In some examples, with reference to Fig. 1 to Fig. 7, the display substrate further includes a second organic layer 520 located on a side of the inorganic layer 210 away from the base substrate 01, a portion of the second organic layer 520 located in the non-display region 032 includes a second film layer 632 of the dam 630, the second film layer 632 is located on a side of the first film layer 631 away from the base substrate 01, and in the direction perpendicular to the base substrate 01, a portion of the inorganic layer pattern 211 that overlaps with the dam 630 is located between the first film layer 631 and the second film layer 632. The second film layer 632 of the dam 630 of the second organic layer 520 located in the non-display region 032 in this embodiment has the same features as the second film layer 632 of the dam 630 of the second organic layer 520 located in the second region 012 in the above embodiment, and the location relationship of the inorganic layer pattern 211, the first film layer 631 and the second film layer 632 in the display substrate according to this embodiment has the same features as the location relationship of the inorganic layer pattern 211, the first film layer 631 and the second film layer 632 in the display substrate according to the above embodiment.

Fig. 26 is a schematic diagram of a partial sectional structure of a non-display region of the display substrate according to an embodiment of the present disclosure.

In some examples, as shown in Fig. 26, the display substrate further includes an encapsulation layer 700 located on a side of the second organic layer 520 away from the base substrate 01, and the encapsulation layer 700 includes a portion in contact with the dam 630 and a portion in contact with the inorganic layer. The encapsulation layer in the display substrate according to this embodiment may have the same features as the encapsulation layer in the display substrate according to the above embodiment.

The structures disposed in the display region in the embodiment of the present disclosure may be the same as the structures disposed in the display region in the above embodiment, such as sub-pixels 300, the pixel defining pattern 5200, and the defining structure 400, etc.

In the above display substrate according to the present disclosure, the inorganic layer located in the display region and the non-display region may be patterned in different ways, such that between adjacent dams in the non-display region, the original passivation layer is replaced to cover the conductive structure to reduce the one-step patterning process, while at the same time reducing crosstalk by isolating, inside the display region, at least one layer of the light-emitting functional layer of the sub-pixels disposed adjacently and having different colors.

The display substrate according to this embodiment may be the same display substrate as the display substrate according to the above embodiment, and may also be a different display substrate having different features, in the non-display region. For example, the display substrate according to this embodiment may include or not include the third region in the above embodiment. For example, this embodiment may only provided with the first isolation column in the above embodiment, or the first isolation column and the second isolation column in the above embodiment may also be disposed at the same time. For example, the first isolation column formed by the conductive structure in the above embodiment may be employed in this embodiment, or the first isolation column formed by stacking up the first inorganic layer and the first organic layer in the above embodiment may also be employed in this embodiment. For example, in the display region in this embodiment, the sidewall of the anode via hole included in the planar layer may be covered or not be covered by the inorganic layer. For example, the display substrate according to this embodiment may include or not include the bending region in the above embodiment.

Provided in another embodiment of the present disclosure is a display substrate. Fig. 27 is a schematic diagram of a partial sectional structure of the display substrate according to an example of the embodiment of the present disclosure. The structures between the dam and the edge position of the first inorganic layer where a crack easily occurs, are omitted in Fig. 27.

As shown in Fig. 27, the display substrate includes a base substrate 01, and a first inorganic layer 210, a first organic layer 510, a second organic layer 520 and a conductive structure 100 located on the base substrate 01. The base substrate 01 includes a first sub-region 021 and a second sub-region 022; the first inorganic layer 210 is located in the first sub-region 021 and the second sub-region 022 of the base substrate 01; the first organic layer 510 is located between a film layer where the first inorganic layer 210 is located, and the base substrate 01; the second organic layer 520 is located on a side of the film layer where the first inorganic layer 210 is located, away from the base substrate 01; the conductive structure 100 is located between the film layer where the first inorganic layer 210 is located, and the base substrate 01. A portion of the first inorganic layer 210 located in the first sub-region 021 is in contact with the first organic layer 510, a portion of the first inorganic layer 210 located in the second sub-region 022 is in contact with the conductive structure 100, and in the first sub-region 021, at least a part of an edge of the first inorganic layer 210 covering the first organic layer 510, is covered by the second organic layer 520. For example, all of the edges of the first inorganic layer 210 covering the first organic layer 510 are covered by the second organic layer 520.

In the display substrate according to the present disclosure, the edge of the first inorganic layer covering the first organic layer is set to be covered by the second organic layer, facilitating preventing a crack on the encapsulation layer covering the edge of the first inorganic layer.

With reference to Fig. 27, the first inorganic layer 210, the first organic layer 510, the second organic layer 520 and the conductive structure 100 in the display substrate according to this embodiment may have the same features as the first inorganic layer 210, the first organic layer 510, the second organic layer 520 and the conductive structure 100 in the display substrate according to any of the above embodiments shown in Fig. 1 to Fig. 26. The first sub-region 021 in the display substrate according to this embodiment may have the same features as a part of the edge of the second region 012 or as the third region 013 in the display substrate according to the above embodiment, and the second sub-region 022 in the display substrate according to this embodiment may have the same features as the non-edge portion of the second region 012 in the display substrate according to the above embodiment. Certainly, the embodiment of the present disclosure is not limited thereto, and when other inorganic layers, such as the second inorganic layer, are also disposed between the conductive structure and the base substrate, the first inorganic layer may also be in contact with the second inorganic layer, in the second sub-region.

In some examples, with reference to Fig. 1 and Fig. 2, the base substrate 01 further includes a third sub-region 023, the first sub-region 021 includes a part of a non-display region, the second sub-region 022 includes a part of the non-display region, and the third sub-region 023 includes a part of a display region; the display region includes a plurality of sub-pixels 300, each sub-pixel 300 of at least a part of the sub-pixels 300 includes a light-emitting functional layer 310, and the light-emitting functional layer 310 includes a plurality of film layers; the display substrate includes a defining structure 400, the defining structure 400 includes a portion of the first inorganic layer 210 located in the first region 011, the defining structure 400 is located between the light-emitting functional layer 310 and the base substrate 01, and a portion of the defining structure 400 located between adjacent sub-pixels 300 is configured to disconnect at least one layer of the light-emitting functional layer 310. The third sub-region 023 in the display substrate according to this embodiment may have the same features as the first region 011 in the display substrate according to the above embodiment, and the sub-pixels 300 and the defining structure 400 in the display substrate according to this embodiment may have the same features as the sub-pixels 300 and the defining structure 400 in the display substrate according to the above embodiment, respectively.

In some examples, with reference to Fig. 1 and Fig. 2, each sub-pixel 300 of at least a part of the sub-pixels 300 further includes a first electrode 320 and a second electrode 330 located on both sides of the light-emitting functional layer 310, and the first electrode 320 is located between the light-emitting functional layer 310 and the base substrate 01; a portion of the second organic layer 520 located in the third sub-region 023 includes a pixel defining pattern 5200 located on a side of the first electrode 320 away from the base substrate 01, the pixel defining pattern 5200 includes a plurality of first openings 5210 and a plurality of second openings 5220, one sub-pixel 300 is corresponding to at least one first opening 5210, the light-emitting functional layer 310 of the sub-pixel 300 is at least partially located in the first opening 5210 corresponding to the sub-pixel 300, and the first opening 5210 is configured to expose the first electrode 320 and the second opening 5220 is configured to expose an edge of the defining structure 400. The pixel defining pattern 5200 and its location relationship with the sub-pixels 300 and the defining structure 400 in the display substrate according to this embodiment may have the same features as the pixel defining pattern 5200 and its location relationship with the sub-pixels 300 and the defining structure 400 in the display substrate according to the above embodiment.

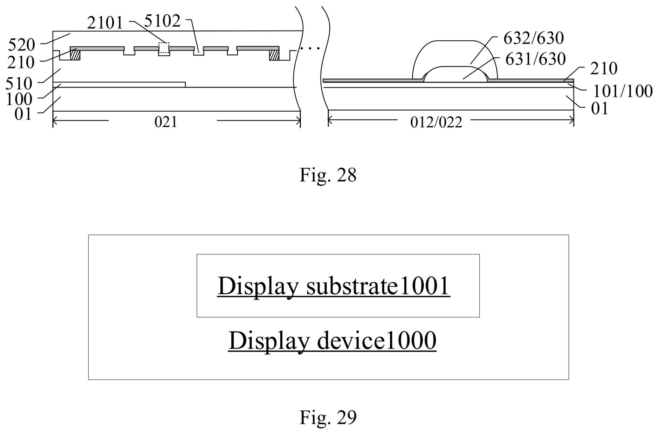

Fig. 28 is a schematic diagram of a partial sectional structure of the display substrate according to another example of the embodiment of the present disclosure.

In some examples, as shown in Fig. 28, a portion of the first inorganic layer 210 located in the first sub-region 021 includes a hole 2101, a portion of the first organic layer 510 located in the first sub-region 021 includes a groove 5102, and a portion of the second organic layer 520 located in the first sub-region 021 fills the hole 2101 and the groove 5102.

During the research, the inventor of the present application has found that when a first organic layer having a large area is disposed between the first inorganic layer and the base substrate in the display substrate, it is bad for outgassing for the first organic layer on one hand; and on the other hand, the presence of a weak adhesion between the first inorganic layer and the first organic layer easily leads to the peeling issue in the first inorganic layer. In the display substrate as shown in Fig. 28 according to the present disclosure, with the hole being disposed in the first inorganic layer 210 on the first organic layer 510 having a large area of coverage so as to expose a part of the first organic layer 510, outgassing for the first organic layer 510 is facilitated; in the meantime, the second organic layer 520, which is located on a side of the first inorganic layer 210 away from the first organic layer 510, fills the hole of the first inorganic layer 210, thus enabling the adhesion of the first organic layer 510 and the second organic layer 520 to solve the peeling issue that easily occurs in the first inorganic layer 210.

In some examples, with reference to Fig. 18 and Fig. 19, the non-display region includes at least one ring-shaped first isolation column 610, the first isolation column 610 includes a first isolation layer 611 and a second isolation layer 612 that are stacked, the first isolation layer 611 is located between the second isolation layer 612 and the base substrate 01, and the second isolation layer 612 protrudes relative to an edge of the first isolation layer 611 in order to disconnect the light-emitting functional layer 310 and the second electrode 330; a portion of the second organic layer 520 located in the non-display region includes the first isolation layer 611, and a portion of the first inorganic layer 210 located in the non-display region includes the second isolation layer 612. The first isolation column 610 including the first isolation layer 611 and the second isolation layer 612 in the display substrate according to this embodiment may have the same features as the first isolation column 610 including the first isolation layer 611 and the second isolation layer 612 in the display substrate according to the above embodiment.

In some examples, with reference to Fig. 19, a side of the first isolation layer 611 away from the base substrate 01 is provided with a first sub-groove 6101, and the second isolation layer 612 exposes the first sub-groove 6101; a portion of the second organic layer 520 located in the non-display region covers the first sub-groove 6101 and an edge of the second isolation layer 612 close to the first sub-groove 6101. The first sub-groove 6101 and the location relationship of the second organic layer 520 and the first sub-groove 6101 in the display substrate according to this embodiment may have the same features as the second groove 614 and the location relationship of the second organic layer 520 and the second groove 614 in the display substrate according to the above embodiment.

In some examples, with reference to Fig. 18 and Fig. 19, the display substrate is provided with at least one second isolation column 620, the second isolation column 620 is located on a side of the first isolation column 610 away from a center of a part of the non-display region that the first isolation column 610 surrounds, the second isolation column 620 includes a third isolation layer 623 and a fourth isolation layer 624 that are stacked, the third isolation layer 623 is located between the fourth isolation layer 624 and the base substrate 01, and an edge of the fourth isolation layer 624 protrudes relative to an edge of the third isolation layer 623 to disconnect the light-emitting functional layer 310 and the second electrode 330; a distance between at least a part of the fourth isolation layer 624 and the base substrate 01 is greater than a distance between the second isolation layer 612 and the base substrate 01. The third isolation layer 623 and the fourth isolation layer 624 in the display substrate according to this embodiment are the first organic layer 510 and the first inorganic layer 210, respectively, and the second isolation column 620 in the display substrate according to this embodiment may have the same features as the second isolation column 620 in the display substrate according to the above embodiment.

In some examples, with reference to Fig. 19, a side of the third isolation layer 623 away from the base substrate 01 is provided with a second sub-groove 6231, and the fourth isolation layer 624 exposes the second sub-groove 6231; the second organic layer 520 covers the second sub-groove 6231 and an edge of the fourth isolation layer 624 close to the second sub-groove 6231. The second sub-groove 6231 in the display substrate according to this embodiment has the same features as the first groove 511 in the display substrate according to the above embodiment, and the location relationship of the second organic layer 520 and the second sub-groove 6231 in the display substrate according to this embodiment has the same features as the location relationship of the second organic layer 520 and the first groove 511 in the display substrate according to the above embodiment.

For example, with reference to Fig. 10, the first inorganic layer 210 covers at least a part of an inner wall of the above anode via hole 5101 in the first organic layer 510, in order to avoid the crack issue during the electrical connection of the first electrode 320 of the sub-pixel 300 with the pixel circuit 340. For example, the first inorganic layer 210 wraps the anode via hole 5101 in the first organic layer 510, the anode via hole 5101 is formed on a surface originally exposed by the first inorganic layer 210, as shown in Fig. 9.

In the above display substrate according to the present disclosure, the first inorganic layer in different regions may be patterned in different ways, such that between adjacent dams in the non-display region, the original passivation layer is replaced with the first inorganic layer to cover the conductive structure, while at the same time reducing crosstalk by isolating, inside the display region, at least one layer of the light-emitting functional layer of the sub-pixels disposed adjacently and having different colors, so on the basis that the one-step patterning process and costs are reduced, the effect of the passivation layer can be achieved so as to solve the GDSX issue in the reliability validation process for this region and also to facilitate an increase in product yield and quality control; and/or, the second isolation column that is formed by stacking up the first inorganic layer and the first organic layer is additionally disposed at a location in the non-display region other than the location of the first isolation column formed by the conductive structure, in order to further disconnect the shared film layers in the light-emitting functional layer and the second electrode of the sub-pixels, help promote the power outage effect of the isolation columns in the non-display region, and alleviate the GDSH issue that easily occurs in the trustworthiness process for this location; and/or, the original first isolation column formed by the conductive structure is replaced with the first isolation column formed by stacking up the first inorganic layer and the first organic layer or other organic layers, thereby saving the one-step patterning process; and/or, the hole exposing the first organic layer is disposed in the first inorganic layer to accomplish outgassing and simultaneously prevent the first inorganic layer from peeling; and/or, the portion of the first inorganic layer that protrudes relative to the edge of the first organic layer is covered by the second organic layer, in order to prevent the crack of the encapsulation layer on the edge of the first organic layer; and/or, the first inorganic layer covers the inner wall of the anode via hole formed in the first organic layer, in order to avoid the pixel dark spot or mura phenomenon caused by the crack of the first electrode (such as anode) on the edge of this anode via hole.

The display substrate according to this embodiment may be the same display substrate as the display substrate according to the above embodiment, and may also be a different display substrate having different features, in the non-display region. For example, this embodiment may employ the first isolation column formed by the conductive structure in the above embodiment, and may also employ the first isolation column formed by stacking up the first inorganic layer and the first organic layer in the above embodiment. For example, the display substrate according to this embodiment may include or not include the bending region in the above embodiment.

Fig. 29 is a schematic block diagram of the display device according to another embodiment of the present disclosure. As shown in Fig. 29, the display device 1000 includes a display substrate 1001. This display substrate 1001 may be the display substrate in any of the above embodiment.

For example, the display device 1000 may be an organic light-emitting display device.

For example, the display device 1000 may also include a cover plate located on a light-emitting side of the display substrate 1001.

For example, this display device 1000 may be any product or component having a display function, such as television, digital camera, mobile phone, watch, tablet, laptop, navigation device, etc., and this embodiment is not limited thereto.

For example, this display device 1000 may be a large and medium-sized smart handheld notebook (NB) or a touch panel controller (TPC), and also has a wide range of application potential in the field of foldable products.

The following statements should be noted:
(1) The accompanying drawings involve only the structure(s) in connection with the embodiment(s) of the present disclosure, and other structure(s) can be referred to common design(s).
(2) In case of no conflict, features in one embodiment or in different embodiments can be combined.

What have been described above are only specific implementations of the present disclosure, the protection scope of the present disclosure is not limited thereto. The protection scope of the present disclosure should be based on the protection scope of the claims.

## Claims

1. A display substrate, comprising:
a base substrate comprising a first region and a second region;
a conductive structure located in the first region and the second region of the base substrate; and
a first inorganic layer located on a side of the conductive structure away from the base substrate and located in the first region and the second region;
wherein, in at least a part of the first region, an insulating layer is disposed between the first inorganic layer and the conductive structure, and in at least a part of the second region, the first inorganic layer is in contact with a surface of the conductive structure.

2. The display substrate according to claim 1, wherein the insulating layer has a thickness greater than that of any layer in the first inorganic layer and the conductive structure.

3. The display substrate according to claim 1 or 2, wherein a portion of the conductive structure located in the second region comprises a power supply signal line.

4. The display substrate according to any one of claims 1 to 3, wherein the first region comprises a display region, and the second region comprises a part of a non-display region;
the display region comprises a plurality of sub-pixels, each of at least a part of the sub-pixels comprises a light-emitting functional layer, and the light-emitting functional layer comprises a plurality of film layers;
the display substrate comprises a defining structure, the defining structure comprises a portion of the first inorganic layer located in the first region, the defining structure is located between the light-emitting functional layer and the base substrate, and a portion of the defining structure located between adjacent sub-pixels is configured to disconnect at least one film layer in the light-emitting functional layer.

5. The display substrate according to claim 4, wherein the insulating layer comprises a first organic layer, a portion of the first organic layer located in the first region is disposed between the first inorganic layer and the conductive structure, the defining structure further comprises at least one raised part in the first organic layer that is in contact with a surface of the first inorganic layer, and at least a part of an edge of the raised part is retracted inward relative to an edge of the first inorganic layer in the defining structure.

6. The display substrate according to any one of claims 1 to 5, wherein the conductive structure comprises at least two sub-conductive structures that are stacked; in a part of the first region, other organic layers are disposed between two adjacent sub-conductive structures of the at least two sub-conductive structures, and in the second region, two adjacent sub-conductive structures of the at least two sub-conductive structures are at least partially in direct contact with each other, or a second inorganic layer is at least disposed between two sub-conductive structures.

7. The display substrate according to claim 5, wherein the base substrate further comprises a third region, the third region comprises a part of the non-display region, a portion of the conductive structure located in the third region comprises at least one ring-shaped first isolation column, and the first isolation column does not overlap with the first organic layer in a direction perpendicular to the base substrate;
each of the at least a part of the sub-pixels further comprises a first electrode and a second electrode located on both sides of the light-emitting functional layer, and the first electrode is located between the light-emitting functional layer and the base substrate;
at least a portion of the first region close to the third region or at least a portion of the third region close to the first region comprises a second isolation column, the second isolation column comprises a stacked structure formed by the first inorganic layer and the first organic layer, in the second isolation column, an edge of the first inorganic layer comprises a first protrusion protruding relative to at least a part of an edge of the first organic layer, and the first isolation column and the second isolation column are configured to disconnect at least one of the light-emitting functional layer and the second electrode.

8. The display substrate according to claim 7, wherein the second isolation column comprises a plurality of second isolation columns surrounding a center of the third region, in at least one second isolation column, the first organic layer is provided with a first groove, and the first inorganic layer comprises an opening exposing the first groove;
the display substrate further comprises a second organic layer located on a side of the first inorganic layer away from the base substrate, and the second organic layer comprises a first covering portion that covers the first groove and an edge of the first inorganic layer close to the first groove.

9. The display substrate according to claim 5, wherein the base substrate further comprises a third region, the third region comprises a part of the non-display region and is provided with at least one ring-shaped first isolation column, the first isolation column comprises a first isolation layer and a second isolation layer that are stacked, and the second isolation layer is located on a side of the first isolation layer away from the base substrate;
a portion of the first organic layer located in the third region comprises the first isolation layer, a portion of the first inorganic layer located in the third region comprises the second isolation layer, and the second isolation layer is disposed to protrude relative to an edge of the first isolation layer to form a second protrusion, or a third organic layer is further disposed between the first organic layer and the base substrate, a portion of the third organic layer located in the third region comprises the first isolation layer, a portion of the first inorganic layer located in the third region comprises the second isolation layer, and the second isolation layer is disposed to protrude relative to an edge of the first isolation layer to form a second protrusion.

10. The display substrate according to claim 9, wherein a side of the first isolation layer away from the base substrate is provided with a second groove, and the second isolation layer exposes the second groove;
the display substrate further comprises a second organic layer located on a side of the first inorganic layer away from the base substrate, and the second organic layer comprises a second covering portion that at least covers the second groove.

11. The display substrate according to claim 8 or 10, wherein a portion of the second organic layer located in the first region further comprises a pixel defining pattern, the pixel defining pattern comprises a plurality of first openings and a plurality of second openings, one sub-pixel is corresponding to at least one first opening, the light-emitting functional layer of the sub-pixel is at least partially located in the first opening corresponding to the sub-pixel, and the first opening is configured to expose the first electrode, and the second opening is configured to expose an edge of the defining structure.

12. The display substrate according to claim 4, wherein each of the at least a part of the sub-pixels further comprises a first electrode and a second electrode located on both sides of the light-emitting functional layer, and a pixel circuit, the first electrode is located between the light-emitting functional layer and the base substrate, and the first inorganic layer is located between the first electrode and the base substrate;
the insulating layer comprises a first organic layer, in a part of the first region, the first organic layer comprises a via hole, the first electrode is electrically connected with the pixel circuit through the via hole, and the first inorganic layer covers at least a part of an inner wall of the via hole.

13. The display substrate according to claim 12, wherein a position of the first organic layer, other than the via hole, comprises at least one raised part in contact with a surface of the first inorganic layer in the defining structure, the defining structure comprises the raised part, and an edge of the raised part is retracted inward relative to an edge of the first inorganic layer in the defining structure.

14. The display substrate according to claim 3, further comprising:
at least one ring of dams that surrounds the display region, at least part of film layers of the dam being located on a side of the conductive structure away from the base substrate,
wherein an orthographic projection of the power supply signal line on the base substrate overlaps with an orthographic projection of the at least one ring of dams on the base substrate, a portion of the power supply signal line located in the second region extends along a first direction, a portion of the at least one ring of dams located in the second region comprises a strip-shaped dam extending along a second direction, at least a portion of the first inorganic layer located in the second region extends along the second direction, and the first direction and the second direction intersect.

15. The display substrate according to claim 14, wherein at least a portion of the first inorganic layer located in the second region comprises at least one inorganic layer pattern, and the inorganic layer pattern covers at least a part of an edge of the power supply signal line that extends along the first direction.

16. The display substrate according to claim 15, wherein the at least one inorganic layer pattern comprises a plurality of inorganic layer patterns, the strip-shaped dam comprises at least one strip-shaped dam, and the strip-shaped dam and the plurality of inorganic layer patterns are alternately disposed along the first direction.

17. The display substrate according to claim 16, wherein an edge of the strip-shaped dam covers an edge of the inorganic layer pattern, or an edge of the strip-shaped dam is flush with at least a part of an edge of the inorganic layer pattern.

18. The display substrate according to any one of claims 14 to 17, wherein the base substrate comprises a fourth region, the fourth region surrounds a part of the display region, and an orthographic projection, on the base substrate, of a portion of the power supply signal line located in the fourth region is completely located in an orthographic projection of the at least one ring of dams on the base substrate.

19. The display substrate according to claim 18, wherein, in the direction perpendicular to the base substrate, the portion of the power supply signal line located in the fourth region does not overlap with the first inorganic layer.

20. The display substrate according to claim 18, wherein the power supply signal line comprises a first power supply signal line and a second power supply signal line, the fourth region is only provided with the second power supply signal line, and the second region is provided with the first power supply signal line and the second power supply signal line.

21. The display substrate according to any one of claims 15 to 17, wherein the display region comprises a plurality of sub-pixels, each of at least a part of the sub-pixels comprises a first electrode, a light-emitting functional layer and a second electrode that are stacked in sequence, and the light-emitting functional layer comprises a plurality of film layers;
the display substrate comprises a defining structure, the defining structure comprises a portion of the first inorganic layer located in the first region, the defining structure is located between the light-emitting functional layer and the base substrate, and a portion of the defining structure located between adjacent sub-pixels is configured to disconnect at least one film layer in the light-emitting functional layer;
the display substrate further comprises a second organic layer located on a side of the first inorganic layer away from the base substrate, a portion of the second organic layer located in the first region comprises a pixel defining pattern, the pixel defining pattern comprises a plurality of first openings, one sub-pixel is corresponding to at least one first opening, the light-emitting functional layer of the sub-pixel is at least partially located in the first opening corresponding to the sub-pixel, and the first opening is configured to expose the first electrode,
a portion of the second organic layer located in the second region comprises a film layer of the dam.

22. The display substrate according to claim 21, wherein the insulating layer comprises a first organic layer, a portion of the first organic layer located in the second region comprises a first film layer of the dam, a portion of the second organic layer located in the second region comprises a second film layer of the dam, the second film layer is located on a side of the first film layer away from the base substrate, and in the direction perpendicular to the base substrate, a portion of the inorganic layer pattern that overlaps with the dam is located between the first film layer and the second film layer.

23. The display substrate according to claim 16, wherein at least one of the plurality of inorganic layer patterns comprises a main body portion extending along the second direction and a widening portion located on at least one side of the main body portion in the first direction, in the second direction, the widening portion has a length smaller than that of the main body portion, in the first direction, the widening portion has a width smaller than a size of the dam, and the widening portion covers an edge of the power supply signal line that extends along the second direction.

24. The display substrate according to claim 8, further comprising:
an encapsulation layer located on a side of the second organic layer away from the base substrate,
wherein at least a part of an edge of the first protrusion closest to a center of the third region, in the second isolation column is covered by the second organic layer, and at least a part of an edge of the second organic layer is covered by the encapsulation layer.

25. The display substrate according to claim 22, further comprising:
an encapsulation layer located on a side of the second organic layer away from the base substrate,
wherein an edge furthest away from the first region in a portion of the first inorganic layer covering the first organic layer and protruding relative to an edge of the first organic layer is covered by the second organic layer, and the encapsulation layer covers at least a part of an edge of the second organic layer.

26. The display substrate according to claim 24 or 25, wherein the first inorganic layer comprises a plurality of notches exposing the first organic layer, and the second organic layer fills the plurality of notches.

27. The display substrate according to claim 1, wherein the base substrate comprises a bending region, the insulating layer comprises a first organic layer, the display substrate further comprises a second organic layer, the second organic layer is located on a side of the first inorganic layer away from the conductive structure, and portions of the conductive structure, the first inorganic layer, the first organic layer and the second organic layer located in the bending region are all configured to be bendable,
a portion of the first inorganic layer located in the bending region comprises a hole, a portion of the first organic layer located in the bending region comprises a third groove, and the second organic layer fills the hole and the third groove.

28. A display substrate, comprising:
a base substrate comprising a first sub-region and a second sub-region;
a first inorganic layer located in the first sub-region and the second sub-region of the base substrate;
a first organic layer located between a film layer where the first inorganic layer is located, and the base substrate;
a second organic layer located on a side of the film layer where the first inorganic layer is located, away from the base substrate; and
a conductive structure located between the film layer where the first inorganic layer is located, and the base substrate;
wherein a portion of the first inorganic layer located in the first sub-region is in contact with the first organic layer, a portion of the first inorganic layer located in the second sub-region is in contact with the conductive structure, and in the first sub-region, at least a part of an edge of the first inorganic layer covering the first organic layer, is covered by the second organic layer.

29. The display substrate according to claim 28, wherein the base substrate further comprises a third sub-region, the first sub-region comprises a part of a non-display region, the second sub-region comprises a part of the non-display region, and the third sub-region comprises a part of a display region;
the display region comprises a plurality of sub-pixels, each of at least a part of the sub-pixels comprises a light-emitting functional layer, and the light-emitting functional layer comprises a plurality of film layers;
the display substrate comprises a defining structure, the defining structure comprises a portion of the first inorganic layer located in the third sub-region, the defining structure is located between the light-emitting functional layer and the base substrate, and a portion of the defining structure located between the adjacent sub-pixels is configured to disconnect at least one film layer of the light-emitting functional layer.

30. The display substrate according to claim 29, wherein each of the at least a part of the sub-pixels further comprises a first electrode and a second electrode located on both sides of the light-emitting functional layer, and the first electrode is located between the light-emitting functional layer and the base substrate;
a portion of the second organic layer located in the third sub-region comprises a pixel defining pattern located on a side of the first electrode away from the base substrate, the pixel defining pattern comprises a plurality of first openings and a plurality of second openings, one sub-pixel is corresponding to at least one first opening, the light-emitting functional layer of the sub-pixel is at least partially located in the first opening corresponding to the sub-pixel, and the first opening is configured to expose the first electrode and the second opening is configured to expose an edge of the defining structure.

31. The display substrate according to any one of claims 28 to 30, wherein a portion of the first organic layer located in the first sub-region comprises a groove, a portion of the first inorganic layer located in the first sub-region comprises a hole exposing at least a part of the groove, and a portion of the second organic layer located in the first sub-region fills the hole and the groove.

32. The display substrate according to claim 28, wherein the base substrate further comprises a third sub-region, the first sub-region comprises a part of a non-display region, the second sub-region comprises a part of the non-display region, and the third sub-region comprises a part of a display region,
the display region comprises a plurality of sub-pixels, each of at least a part of the sub-pixels comprises a light-emitting functional layer and a first electrode and a second electrode located on both sides of the light-emitting functional layer, and the first electrode is located between the light-emitting functional layer and the base substrate;
the non-display region comprises at least one ring-shaped first isolation column, the first isolation column comprises a first isolation layer and a second isolation layer that are stacked, the first isolation layer is located between the second isolation layer and the base substrate, and the second isolation layer protrudes relative to an edge of the first isolation layer to disconnect the light-emitting functional layer and the second electrode;
a portion of the second organic layer located in the non-display region comprises the first isolation layer, and a portion of the first inorganic layer located in the non-display region comprises the second isolation layer.

33. The display substrate according to claim 32, wherein a side of the first isolation layer away from the base substrate is provided with a first sub-groove, and the second isolation layer exposes the first sub-groove;
a portion of the second organic layer located in the non-display region covers the first sub-groove and an edge of the second isolation layer close to the first sub-groove.

34. The display substrate according to claim 32 or 33, wherein the display substrate is provided with at least one second isolation column, the second isolation column is located on a side of the first isolation column away from a center of a part of the non-display region that the first isolation column surrounds, the second isolation column comprises a third isolation layer and a fourth isolation layer that are stacked, the third isolation layer is located between the fourth isolation layer and the base substrate, and an edge of the fourth isolation layer protrudes relative to an edge of the third isolation layer to disconnect at least one of the light-emitting functional layer and the second electrode;
a distance between at least a part of the fourth isolation layer and the base substrate is greater than a distance between the second isolation layer and the base substrate.

35. The display substrate according to claim 34, wherein a side of the third isolation layer away from the base substrate is provided with a second sub-groove, and the fourth isolation layer exposes the second sub-groove;
the second organic layer covers the second sub-groove and an edge of the fourth isolation layer close to the second sub-groove.

36. A display substrate, comprising:
a base substrate comprising a display region and a non-display region surrounding the display region;
an inorganic layer located in the display region and the non-display region of the base substrate;
a conductive structure located between the inorganic layer and the base substrate and comprising a power supply signal line;
at least one ring of dams located in the non-display region and surrounding the display region, at least part of film layers of the dam being located on a side of the conductive structure away from the base substrate,
wherein the non-display region comprises a first non-display region located on a side of the display region, a portion of the power supply signal line located in the first non-display region extends along a first direction, a portion of the dam located in the first non-display region comprises a strip-shaped dam extending along a second direction and overlapping with the power supply signal line, a portion of the inorganic layer located in the first non-display region comprises an inorganic layer pattern extending along the second direction, and in a direction perpendicular to the base substrate, an edge of the strip-shaped dam overlaps with at least a part of an edge of the inorganic layer pattern.

37. The display substrate according to claim 36, wherein the non-display region comprises a second non-display region surrounding the display region, an orthographic projection, on the base substrate, of a portion of the power supply signal line located in the second non-display region, is completely located in an orthographic projection of the at least one ring of dams on the base substrate.

38. The display substrate according to claim 37, wherein, in the direction perpendicular to the base substrate, a portion of the power supply signal line located in the second non-display region does not overlap with the inorganic layer.

39. The display substrate according to claim 37, wherein the power supply signal line comprises a first power supply signal line and a second power supply signal line, the second non-display region is only provided with the second power supply signal line, and the first non-display region is provided with the first power supply signal line and the second power supply signal line.

40. The display substrate according to any one of claims 36 to 39, wherein the at least one inorganic layer pattern comprises a plurality of inorganic layer patterns, the strip-shaped dam comprises at least one strip-shaped dam, and the strip-shaped dam and the plurality of inorganic layer patterns are alternately disposed along the first direction.

41. The display substrate according to any one of claims 36 to 40, wherein the inorganic layer pattern covers an edge of the power supply signal line that extends along the first direction.

42. The display substrate according to claim 40, further comprising:
a first organic layer located between the inorganic layer and the base substrate, a portion of the first organic layer located in the display region comprising a planar layer,
wherein a portion of the first organic layer located in the non-display region comprises a first film layer of the dam, and a portion of the inorganic layer that overlaps with the dam in the direction perpendicular to the base substrate covers at least a part of an edge of the first film layer.

43. The display substrate according to claim 42, further comprising:
a second organic layer located on a side of the inorganic layer away from the base substrate,
wherein a portion of the second organic layer located in the non-display region comprises a second film layer of the dam, the second film layer is located on a side of the first film layer away from the base substrate, and in the direction perpendicular to the base substrate, a portion of the inorganic layer pattern that overlaps with the dam is located between the first film layer and the second film layer.

44. The display substrate according to claim 43, further comprising:
an encapsulation layer located on a side of the second organic layer away from the base substrate,
wherein the encapsulation layer comprises a portion in contact with the dam and a portion in contact with the inorganic layer.

45. A display device, comprising the display substrate according to any one of claims 1 to 44.
